# EUROPEAN PATENT SPECIFICATION

(11) **EP 2 739 992 B1**
(45) Date of publication and mention of the grant of the patent: **14.10.2015**
(21) Application number: 11757940.9
(22) Date of filing: 02.08.2011
(51) Int. Cl.: G01T 1/24

(54) **DIRECT DETECTORS FOR IONIZING RADIATIONS, AND METHODS FOR PRODUCING SUCH DETECTORS**
DIREKTE DETEKTOREN FÜR IONISATIONSSTRAHLUNGEN UND VERFAHREN ZUR HERSTELLUNG SOLCHER DETEKTOREN
DÉTECTEURS DIRECTS DE RAYONNEMENTS IONISANTS ET PROCÉDÉS DE PRODUCTION DE CES DÉTECTEURS

(43) Date of publication of application: 11.06.2014
(73) Proprietor: Alma Mater Studiorum -Universita' di Bologna, 40126 Bologna (IT); Elettra - Sincrotrone Trieste S.C.P.A., 34149 Basovizza - Trieste (IT)
(72) Inventor: FRABONI, Beatrice, I-40126 Bologna (IT); FRALEONI MORGERA, Alessandro, I-34149 Basovizza - Trieste (IT)
(74) Representative: Montevecchi, Emma
(86) International application number: PCT/IB2011/053436
(87) International publication number: WO 2013/017915

(56) References cited:
- WO-A1-01/94980
- FR-A1- 2 799 003
- US-A1- 2009 179 155
- US-B1- 7 186 987
- B. Fraboni ET AL: "Three-dimensional anisotropic density of states distribution and intrinsic-like mobility in organic single crystals", Organic Electronics, vol. 11, no. 1, 1 January 2010 (2010-01-01), pages 10-15, XP055163520, ISSN: 1566-1199, DOI: 10.1016/j.orgel.2009.09.014

## Description

The present invention relates to organic semiconductors to be used as intrinsic, direct detectors for ionizing radiations, such as X and gamma rays, neutrons, and charged particles (alpha rays, electrons, positrons, and the like), and to a method for manufacturing such intrinsic, direct detectors for ionizing radiations.

The invention further relates to instruments or complex devices provided with a detector based on, or somehow incorporating, organic semiconductors used as intrinsic, direct detectors for ionizing radiations. In particular, the instruments according to the present invention are useful as X-ray detectors in medical field, for example in dentistry, medical imaging; in civil field, for example in airports, borders and in analytical techniques, or in R&D or industrial activities.

### Background of the invention

The detection of ionizing radiations is an important task in a number of technologically and socially relevant activities, spanning from microelectronics to sanitization and sterilization, from industrial quality control to the oil industry, from mining to medicine (Handbook on Radiation Probing, Gauging, Imaging and Analysis - Vol. II: Applications and Design, Ed. Esam M.A. Hussein, 2003 Kluwer Dordrecht; Industrial applications of X-ray diffraction, Ed. F. H. Chung, D. K. Smith, M. Dekker, NY (USA), 2000; Understanding X-Rays: A Synopsis of Radiology, Ed. F. van Gelderen, Springer Verlag Berlin 2004; Ionizing radiations detectors for medical imaging, Ed. A. Del Guerra, World Scientific, Singapore, 2004)). Therefore, the development of detectors for ionizing radiations is a technologically, economically and socially relevant field of studies.

Several kinds of detectors for ionizing radiations exist.

A "direct detector" for ionizing radiations is here defined as a device in which the incoming ionizing radiation is transduced directly into an electrical signal.

An "intrinsic, direct detector" is here defined as a direct detector in which the incoming ionizing radiation is transduced directly into an electrical signal, such transduction occurring within the same material interacting with the ionizing radiation, rather than in a material near to, or in contact with, that interacting with the ionizing radiation.

An "indirect detector" is here defined as a device in which the incoming ionizing radiation is detected in a two-steps process, the first step being performed by a first device (a "scintillator"), and consisting in the transduction of the radiation into photons (i.e. not directly into an electrical signal), and the second step being performed by a second device (a "photodiode") converting these photons into an electrical signal. The two aforementioned devices have to be coupled to obtain a complete, operative ionizing radiations indirect detector.

The state-of-the-art indirect detectors for ionizing radiations available on the market are constituted either by inorganic or by organic materials, sometimes by devices based on organic materials coupled to devices based on inorganic ones. Examples of inorganic materials-based scintillators to be used in indirect detectors are those relying on Tallium-doped Cesium Iodide (CsI(TI), see for example patent US 7,608,836) or Bismuth Germanate (BGO, see for example patent US 5,171,986). However, inorganic materials-based scintillators are relatively expensive. Therefore, organic-based scintillators, less expensive than inorganic-based ones, have been developed. These latter come usually in the form of plastic materials, as organic scintillating molecules embedded in a polymeric matrix (for example patent US 4,713,198). Also organic single crystals have been utilized as scintillators to convert X rays and gamma rays into light and for the neutron-gamma discrimination by means of pulse shape analysis procedures (Hull, G. et al., IEEE Trans. Nucl. Sci. 56, 899 (2009); Zaitseva et al., US 2010/0252741). Moreover, organic polycrystalline films have been used as scintillators (L. A. Andryushchenko et. al., Instr. Exp. Techniques, 2003, 46, 591). Organic materials may be used in indirect detectors not only as scintillators, but also as photodiodes, provided that they have semiconducting properties. In particular, organic semiconducting polymers have been used as photodiodes coupled to inorganic scintillators (Keivanidis, P. et al., Appl. Phys. Lett. 92 23304 (2008); Agostinelli, T. et al., Appl. Phys. Lett. 93 203305 (2008)). In fact, it has been shown that thin films based on semiconducting polymers can withstand high X-rays doses without significant material degradation (Newman, R. et al., Appl. Phys. Lett. 91 142105 (2007)). However, the polymers must be properly encapsulated to protect them from the environmental oxygen and water, otherwise significant degradation of the device occurs rapidly (Atreya M. et al., Polym. Degrad. Stab. 65 (1999) 287). It has to be noted that an effective encapsulation of semiconducting polymers-based devices leads to markedly increased production costs, which is not desirable.

In general, the architecture of indirect radiation detectors, i.e. detectors formed by scintillators coupled to photodiodes, is not optimal for an ionizing radiations detector. First of all, it causes a certain information loss in the complete radiation detection process, this disadvantage being particularly evident for low radiation doses. A further disadvantage of indirect detectors is that the more complex device structure, which is actually composed by two distinct, though coupled, devices, leads to relatively high fabrication and maintenance costs. Therefore, it may be desirable to develop more efficient devices. Moreover, when organic semiconductors are used in the photodiode part of an indirect detector, problems arising from large spreads in the charge transport parameters of these materials, which hinder a proper working of the whole detector, are noticed.

It is hence convenient to develop direct detectors for ionizing radiations.

The state-of-the-art direct detectors available on the market are constituted by inorganic materials, based for example on silicon, cadmium telluride, diamond, and the like. All these detectors are, according to the above given definitions, intrinsic, direct detectors, i.e. they base their detection capabilities on the direct transduction of the ionizing radiation into an electrical signal within the same material interacting with the ionizing radiation. Intrinsic, direct detectors have advantages over simple direct detectors (or, briefly, direct detectors). In fact, intrinsic, direct detectors do not require the presence of multiple materials in the device portion exposed to ionizing radiations for achieving the detection of the latter, thus resulting in less expensive fabrication architecture. Moreover, the presence of multiple materials and the necessity of transferring the electrical signal from one material to another one in the same device, as the skilled in the art will understand, lower the overall efficiency of the device.

Examples of intrinsic, direct detectors are disclosed in US 2004/0084626, to McGregor, or in US 2009/0302226 to Yissum Research Development Company of the Hebrew University of Jerusalem, disclosing a polycrystalline, inorganic semiconductor as detector, and also in US2010/0078570, to Innovative American Technology, Inc. with a gallium arsenide-based semiconductor. However, inorganic-based intrinsic, direct detectors are quite expensive. Moreover, they require predetermined experimental conditions to work properly, for example an operative temperature lower than the environmental one, and often their architecture is pretty complicated, which results in problems related to operability, reliability and maintenance. Therefore, both the purchasing and the operating costs for these devices are very high.

It is hence crucial and pressing to develop less expensive intrinsic, direct detectors for ionizing radiations. In this view, organic semiconductors are interesting materials. In electronic/optoelectronic applications they already demonstrated room temperature operation, low environmental impact and low fabrication costs (Berggren et al., Adv. Mater. 19, 3201 (2007); Capelli, R. et al., Nature Mater. 9, 496 (2010); Roeling, E. et al. Nature Mater. 10 51-55 (2011)). Moreover, optically transparent and flexible electronic and optoelectronic devices can be fabricated, allowing unprecedented and integrated device architectures (Sekitani, T. et al. Nature Mater. 9, 1015 (2010); Jeon, K.M. et al., NSTI-Nanotech 2010 Technical Proceedings, 2010, 3, 712).

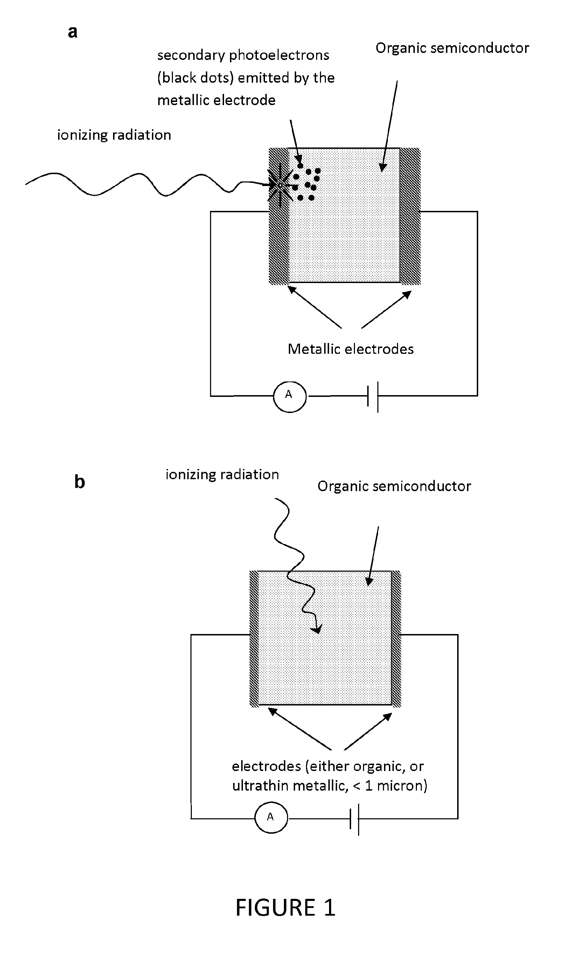

However, up to date, only a few examples of simple, direct detectors based on organic semiconductors are reported, and they all refer to thin films based on organic semiconducting polymers (Beckerle, P. et al, Nucl. Instr. Meth. Phys. Res. A 449 302 (2000); Boroumand, F. et al., Appl. Phys. Lett. 91 33509 (2007); Intaniwet, A. et al., J. Appl. Phys. 106 64513 (2008)). Though the authors of these reports do not mention explicitly that they are dealing with simple, direct detectors, it has to be noticed that in these devices the polymeric semiconductors thin films are always coupled to metallic electrodes or substrates, which are exposed to the ionizing radiation together with the organic layer. The importance and the role of the metallic electrodes and/or the substrate in the performance of these devices are stressed out in several dedicated works, as for example Newman, R. et al. Appl. Phys. Lett. 91 142105 (2007); Keivanidis P. et al., Appl. Phys. Lett. 92, 23304 (2008), Intaniwet et. al, Appl. Mater. Interf., 2010, 2, 1692. Also in the patent US 7,186,987, to Doty et al., which claims a direct ionizing radiations detector comprising "an array of wires embedded in a solid organic semiconducting material" and discusses as the only enabling example a device in which the organic semiconductor is a polymeric semiconductor, the presence of metallic electrodes in form of wires is taught to be an essential and necessary element of the invention, since the wires/electrodes have to be directly illuminated by the ionizing radiation for achieving a proper operability of the device, as stressed out both in the figures (Figure 1), and in claims 19-23, where it is explicitly stated that the device works "detecting the signal generated when the radiation strikes the wires (i.e., the electrodes)". Although Doty et al. apparently provide the possible presence of organic electrodes, the only working and enabling example in this patent shows the device equipped with metallic electrodes and the devices works because the radiation strikes the electric wire, generating a secondary electron, which is then detected in the organic semiconductor polymer making the detector body.

As another example of simple, direct ionizing radiation detector, WO 2009/091646 discloses a device comprising an organic polymeric matrix with a plurality of metallic/semi metallic nanoparticles suspended in the matrix, with the particles being capable of generating at least one charge carrier upon interaction with radiation. On page 12, paragraph 0056, this reference clearly teaches that the nanoparticles (14) are expected to be made by one or more materials with atomic numbers greater than the materials forming the host matrix (12) (e.g., higher Z materials than the host matrix (12)). The skilled person understands that, consequently, the nanoparticles (14) must be metallic or semi metallic.

While the above mentioned disclosures highlight the need for metallic/semi metallic electrodes or elements for the practical operation of direct detectors of ionizing radiations, many other publications and patents do not explicitly recognize this point, nonetheless they always report the use of metallic electrodes that are illuminated by the ionizing radiations in the description of the exposed devices (see for example WO 2010/046904, to Raval et al., which describes the use of thin films of semiconducting polymers plain layers deposed on interdigitated electrodes as the sensing element of a detector for ionizing radiations. In such a device it is not possible to have the ionizing radiation passing through just the polymer, avoiding the interdigitated electrodes). Therefore, it is evident to the skilled in the art of ionizing radiation detectors that in the scientific and technical field there exists a common opinion stating that the possibility of realizing detectors for ionizing radiations including organic semiconductors is based on the presence, in the device, of metallic/semi metallic electrodes or substrates, which are known to emit secondary photoelectrons upon interaction with ionizing radiations. Moreover, these metallic/semi metallic elements have to be irradiated by the ionizing radiation in order to have a proper response from the device. In particular, it is believed that the role of the organic material is mostly that of collecting the secondary electrons produced by the interaction of the ionizing radiation with the metallic/semi metallic electrodes/substrate, helping thus in generating a detectable photocurrent. This technical prejudice is somehow justified by the currently available know-how on the absorption coefficients for ionizing radiations of light elements like carbon, hydrogen, oxygen or even sulfur, the main constituents of organic materials, which are generally low, and are not reputed high enough to allow a satisfactory interaction with the ionizing radiation. Indeed, in the few cases where researchers affirm that the presence of several hydrogen atoms in organic compounds could be beneficial for the detection of neutrons, the detector architecture involves in any case some metal electrode that must be exposed to the ionizing radiation in order to have an active device (see the previously mentioned US 7,186,987). Moreover, it is known that organic materials are characterized by low carrier mobilities, and that it is difficult to obtain an efficient electrical contact between organic semiconductors and metals (see for example Y. Shen et al., Chem. Phys. Chem. 2004, 5, 16). This means that if a charge is created within the organic semiconductor directly upon interaction with the ionizing radiation, its extraction from the material via metallic electrodes is rather difficult. When this is considered in the frame of the quite low number of charges generated by the weak interaction of ionizing radiations with an organic thin film, the fabrication of detectors based on organic semiconductors as intrinsic detectors appears even more difficult. In view of these considerations, the above mentioned references have to be considered enabling only as far as metallic electrodes are provided, since the skilled person do not believe such a detector working when organic electrodes are used. Finally, the above discussed disclosures related to organic semiconductors used in simple, direct detectors, which to the best knowledge of the present inventors represent the state-of-the-art in the field, are based on very thin (at most a few hundreds of micrometers thick) films comprising semiconducting polymers, which, given the limited ionizing radiations absorption coefficients of organic materials, offer a very limited interaction volume for the incoming ionizing radiation beam, further reducing their possible absorption/conversion efficacy. In other words, it is evident that those skilled in the art do not recognize, explicitly or implicitly, a significant possibility to use an organic semiconductor as an intrinsic, direct detector for ionizing radiations *per se,* without relying on the contribution of heavy atoms (like metallic or semi metallic ones) somehow inserted in the device (for example, as electrodes or substrates). This is explicitly recognized by several researchers in the field (see for example Newman, R. et al. Appl. Phys. Lett. 91 142105, 2007; Keivanidis P. et al., Appl. Phys. Lett. 92, 23304 (2008)).

Besides this consideration, it is worth to recall that the already mentioned issue of degradation of semiconducting polymers represents an additional problem for the fabrication of effective semiconducting polymer-based intrinsic, direct detectors. In fact, many of the above cited detectors (like for example WO 2010/046904) base their operability on the measurement of the resistivity (conductivity) of the polymeric semiconductor, which increases (decreases) upon device exposure to the ionizing radiation, due to material degradation. This means that the above described devices are not able to perform for prolonged times, neither to be repeatedly used with reproducible performances, resulting hence as detectors with a very short operative lifetime and, in the best possible case, as disposable devices, in the worst case as non-operable devices. Such disadvantages may be overcome using particular organic semiconductors, like those disclosed in a degree dissertation (Fattori-Università di Bologna, December 2009) in which organic semiconducting single crystals coupled to metal substrates, and with metallic electrical contacts, were used as parts of simple, direct X-ray detectors. There is no recognition that the device is an intrinsic, direct detector. In a still further dissertation (Ciavatti-Università di Bologna, December 2010), the same device discussed above (i.e. an organic semiconducting single crystal built on metal pads and with metal contacts) was used as a simple, direct detector for alpha particles. These dissertations have also been partially exposed in the International Conference on Room Temperature Semiconductor Detectors (RTSD)", Knoxwille, TN (U.S.A), November 2010, where the devices have been presented as examples of simple, direct detectors for ionizing radiations, using metallic electrodes or substrates together with the organic semiconductor. Other available reports on direct detectors for ionizing radiations exploiting organic single crystals include Zuppiroli et al. (Int. J. Appl. Radiat. Isot. 36 843, 1985), which discloses the fabrication of direct ionizing radiations detectors based on charge-transfer, conducting organic single crystals. In the very same work the authors irradiated the metal electrodes together with the organic crystal (which makes the described device a simple, direct detector), and in the end underlined that the considered materials are not air-stable and present several problems related to their mechanical fragility, hence they are not useful for practical application. It has to be noted that also in this latter work, the Authors operate the detector along the lines of the general teaching of the state of the art, namely irradiating the metallic electrodes with the ionizing radiation, in order to ensure the generation of secondary electrons in order to raise a response in the detector.

When considering simple, direct detectors with respect to the presence of metallic components in the device, it is important to underline that charged particles like alpha or beta radiation, which are a technologically important subset of ionizing radiations, have a very limited penetration depth in metals, i.e., metallic layers even as thin as a few microns can stop charged particles, lowering hence the detection possibilities for these kind of ionizing radiations. It is hence understood that intrinsic, direct detectors based on organic semiconductors (where metals or semimetals are absent, or however not present in quantities able to absorb appreciably the ionizing radiation), capable of detecting ionizing radiations otherwise stopped by simple direct detectors, would be desirable. Nonetheless, as evidenced above, it is clear that no example of intrinsic, direct detectors based on organic semiconductors for the detection of ionizing radiations has ever been disclosed. Moreover, from the reported state of the art it is apparent that the actual concept of an intrinsic, direct detector based on organic semiconductors is not accepted as feasible by the currently available technical knowledge.

Therefore, the making available intrinsic, direct detectors based on organic semiconductors would represent a great advance in the field of ionizing radiation detectors, solving several practical issues with reference to the above mentioned open issues and to the cited prior art.

It has now surprisingly been found that organic semiconductors can be used as intrinsic, direct detectors for ionizing radiations. This finding is totally unexpected, since the detection of the ionizing radiation occurs without metallic/semi metallic components interacting with the ionizing radiation be necessarily present.

### Summary of the invention

For the purpose of the present invention, the following definitions are given.

For the purpose of the present invention, as "ionizing radiation" it is intended a radiation or charged particle which, upon hitting the detector, generates ions. Examples of ionizing radiations are gamma-, alpha-, beta-, neutron- and X-radiation, electrons, positrons. The complete list of the known ionizing radiations addressed by this invention is given in "Handbook on Radiation Probing, Gauging, Imaging and Analysis", Ed. Esam M.A. Hussein, 2003 Kluwer Dordrecht.

An "organic semiconductor" is an organic-based compound that shows semiconducting properties in a crystalline (either single crystalline or polycrystalline) form. For the purposes of this invention, the term "semiconductor" is attributed to compounds having a band gap between 0.5 eV and 6 eV.

A "simple, direct detector" for ionizing radiations is a device in which the incoming ionizing radiation is transduced directly into an electrical signal.

An "intrinsic, direct detector" is a direct detector in which the transduction occurs within the same material interacting with the ionizing radiation, rather than in a material near to, or in contact with, that interacting with the ionizing radiation.

An "indirect detector" is a device in which the incoming ionizing radiation is detected in a two-steps process, the first step being performed by a first device (a "scintillator"), and consisting in the transduction of the radiation into photons (i.e. not directly into an electrical signal), and the second step being performed by a second device (a "photodiode") converting these photons into an electrical signal. The two aforementioned devices have to be coupled to obtain a complete, operative ionizing radiation indirect detector.

It is an object of the present invention to provide organic semiconductor-based intrinsic, direct detectors for ionizing radiations, as defined in claim 1, which in turn can be electrically connected to a proper signal processing circuit by means of electrodes.

The detectors according to the present invention are capable of generating an electrical current consequent to the detection of the ionizing radiation within the same material interacting with the ionizing radiation, being this material an organic semiconductor.

Another object of the present invention is to provide intrinsic, direct detectors for ionizing radiations where the electrodes connecting them to a proper signal processing circuit are organic, as detailed in the foregoing description.

Another object of the present invention is to provide intrinsic, direct detectors for ionizing radiations where the electrodes connecting them to a proper signal processing circuit are ultrathin (approximately less than 1 micrometer thick) metal or semimetal layers, as detailed in the foregoing description.

Another object of the present invention is to provide detectors for ionizing radiations comprising organic semiconductor-based intrinsic, direct detectors capable of being flexed.

Another object of the present invention is to provide detectors for ionizing radiations comprising organic semiconductor-based intrinsic, direct detectors, being optically transparent.

Another object of the present invention is to provide detectors for ionizing radiations comprising organic semiconductor-based intrinsic, direct detectors operable at room temperature and in atmospheric environment.

Another object of the present invention is to provide detectors for ionizing radiations comprising organic semiconductor-based intrinsic, direct detectors capable of air-stability, reversibility, dose-related linear response and prolonged exercise (in a fully reversible fashion), also in a radiation-hard environment, having reproducible results even after several months of inactivity or after prolonged activity under different kinds of ionizing radiations and/or even in radiation-hard conditions.

Another object of the present invention is to provide detectors for ionizing radiations comprising organic semiconductor-based intrinsic, direct detectors capable of being operated in a wide range of bias voltages, ranging from tens to thousands of volts, with no appreciable sign of performance degradation.

Another object of the present invention is to provide detectors for ionizing radiations comprising organic semiconductor-based intrinsic, direct detectors capable of being operated without any kind of encapsulation.

Another object of the present invention is to provide detectors for ionizing radiations comprising organic semiconductor-based intrinsic, direct detectors, where the organic semiconducting intrinsic, direct detector is an organic single crystal.

Another object of the present invention is to provide detectors for ionizing radiations comprising organic semiconductor-based intrinsic, direct detectors, where the organic semiconducting intrinsic, direct detector is an organic polycrystal.

Another object of the present invention is to provide detectors for ionizing radiations comprising organic semiconductor-based intrinsic, direct detectors, capable of showing a well-defined two-dimensional (2D) or three-dimensional (3D) structure, that allows a well-defined 2D or 3D anisotropic response to an interacting ionizing radiation.

Another object of the present invention is to provide detectors for ionizing radiations comprising organic semiconductor-based intrinsic, direct detectors, capable of being size-tunable in a range encompassing tens of micrometers to centimeters.

Another object of the present invention are methods for the manufacture of said detector, as disclosed in detail in the foregoing description.

Another object of the present invention is to provide detectors for ionizing radiations comprising organic semiconductor-based intrinsic, direct detectors, capable of being grown directly on a substrate.

Another object of the present invention is to provide detectors for ionizing radiations comprising organic semiconductor-based intrinsic, direct detectors, capable of being grown by solution growth, as disclosed in detail in the foregoing description.

Another object of the present invention is to provide detectors for ionizing radiations comprising organic semiconductor-based intrinsic, direct detectors grown by solution growth, and then selectively placed onto the substrate, that may be or not provided by electrodes.

Another object of the present invention is to provide an instrument or a complex device comprising one or more of the above mentioned organic semiconductor-based intrinsic, direct detectors of ionizing radiations.

The intrinsic, direct detectors for ionizing radiations provided by the present invention solve the problems of the prior art and are endowed with different advantages. Their manufacture is simple and more economic than the inorganic intrinsic, direct detectors of the prior art. Moreover, their response is linear and reproducible. They can be also endowed with anisotropic response, allowing to determine the direction of the incident radiation. Their manufacture is simpler, since they can be solution-grown and quite advantageously on a patterned substrate, provided with the electrical circuit. They can be transparent and flexible. They operate in normal conditions, room temperature and atmospheric pressure. They are long-standing devices and stable in radiation-hard environment. Other advantages will become apparent in the foregoing description.

All the above scopes are specific objects of the invention and will be described hereafter, also by means of Figures and Examples, with a comprehensive and exhaustive demonstration of the intrinsic nature of the direct detection of ionizing radiations by means of organic semiconducting materials.

### Detailed description of the invention

The invention will be now described with reference to the following figures:
Figure 1a - Sketch of a simple direct detector of ionizing radiations based on an organic semiconductor
Figure 1b - Sketch of an intrinsic, direct detector of ionizing radiations based on an organic semiconductor

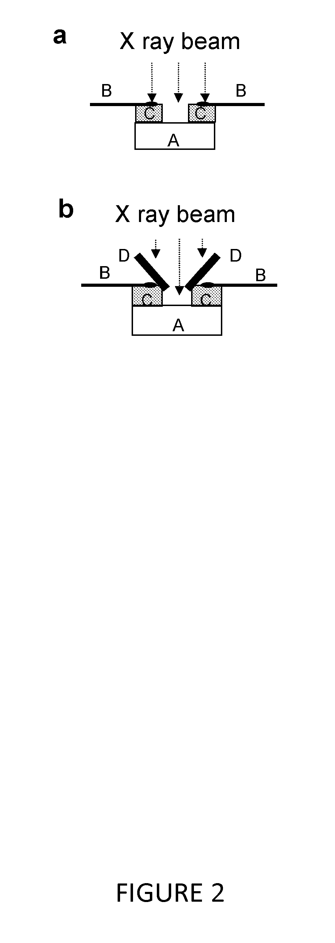

Figure 2 - Measurement setups used for assessing the intrinsic detection response to an ionizing radiation (in this case X-rays) by the organic semiconductor. a) Setup in which the X-rays are allowed to hit the metallic contacts (B = metallic wires; C = metallic pads) and the detecting element (A); b) setup in which the X-rays are allowed to hit only the detecting element A, while the metallic contacts (B = metallic wires; C = metallic pads) are shielded from X-rays by means of lead (Pb) shields (D)

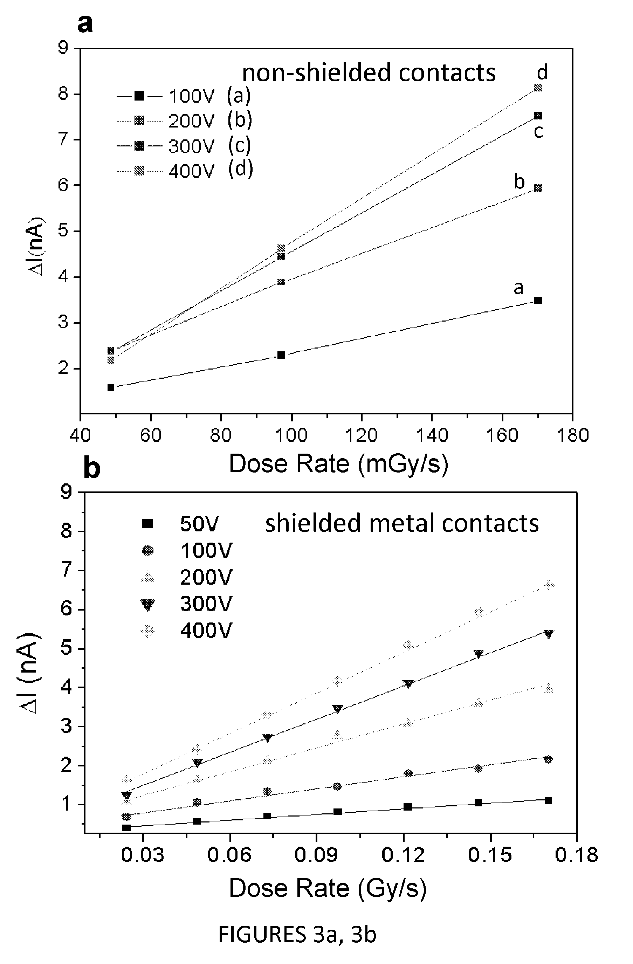

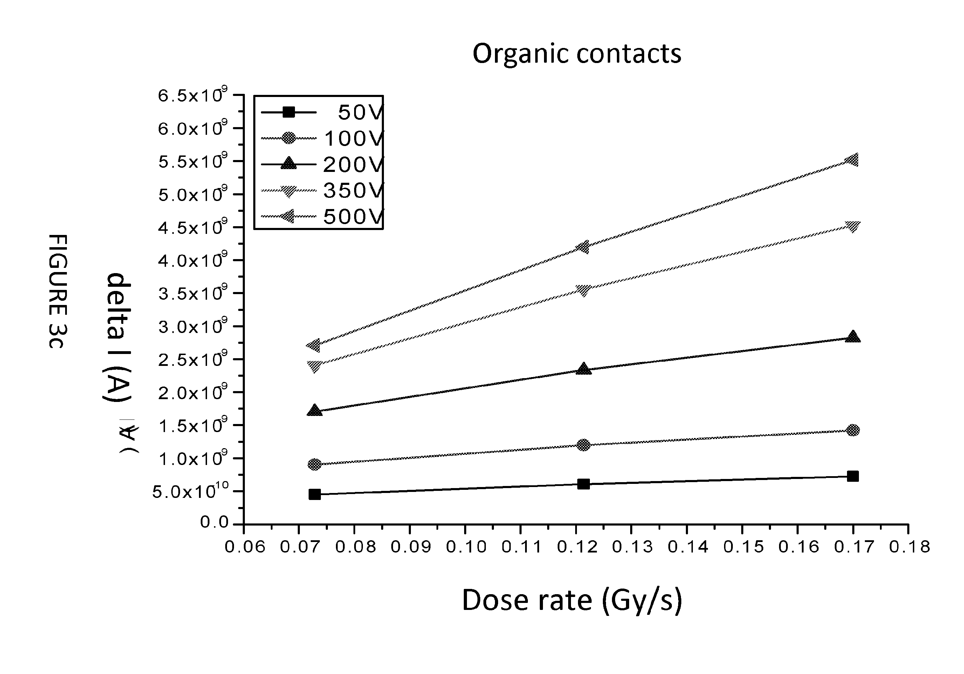

Figure 3 - Effect of the shielding of metallic contacts from X-rays on the response of a 4-hydroxycyanobenzene (4HCB) single crystal-based X-rays detector. a) Electrical response under X ray irradiation of a complete device with a 4HCB crystal with non-shielded metal contacts (measurement setup as in Figure 2a) along the planar axis of the crystal; b) Electrical response under X ray irradiation of a complete device with a 4HCB crystal with shielded metallic contacts (measurement setup as in
Figure 2b) along the planar axis of the crystal; c) Electrical response under X ray irradiation of a complete device with a 4HCB crystal with non-shielded organic conductive contacts (Poly(3,4-ethylenedioxythiophene):poly(styrenesulfonate), PEDOT:PSS; measurement setup as in Figure 2a) along the planar axis of the crystal.

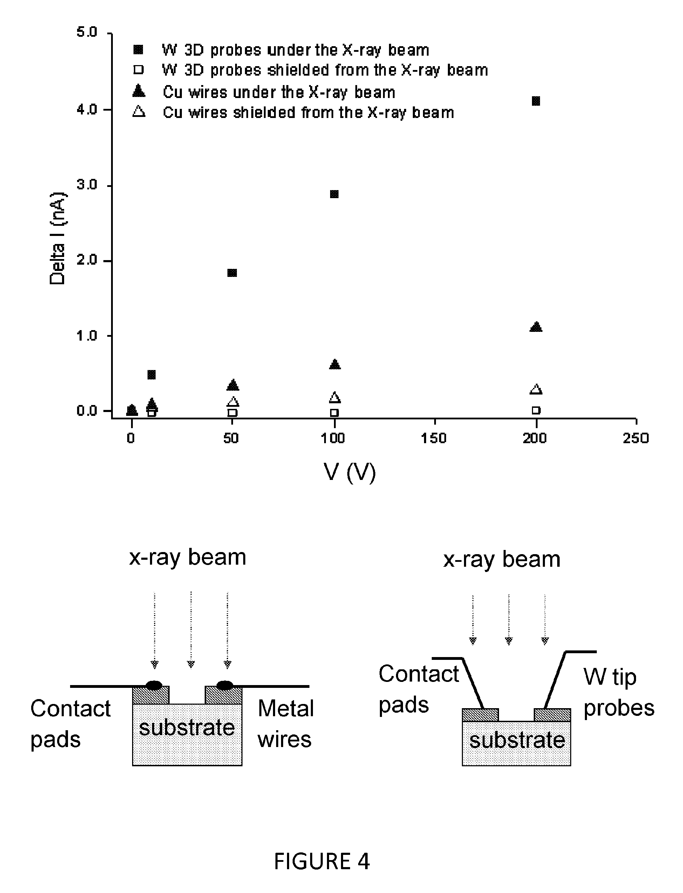

Figure 4 - Effect of the irradiation of metallic contacts with X-rays. Electrical response Delta I (ION-IOFF) under X ray irradiation of a complete device (quartz substrate and electrodes) without the active 4HCB organic crystal. The response is reported for electrodes connected with Cu wires and W 3D tip probes (see figure inset) placed either directly under the X-ray beam or shielded from it. It is evident how directly exposing metal contacts to an X-ray beam in air induces the readout of an electrical signal (more marked in the W tips due to their 3D structure).

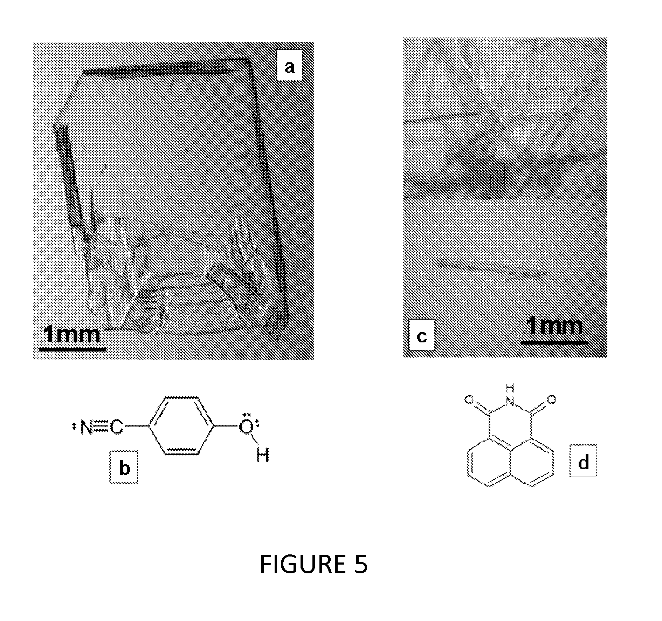

Figure 5 - Crystal appearance and molecular structure of 4HCB and 1,8-naphthalenediimide (NTI). a, b, c, d, Optical microscopy photos (a, c) and molecular structure (b, d) of single crystals of 4HCB (a, b) and NTI (c, d).

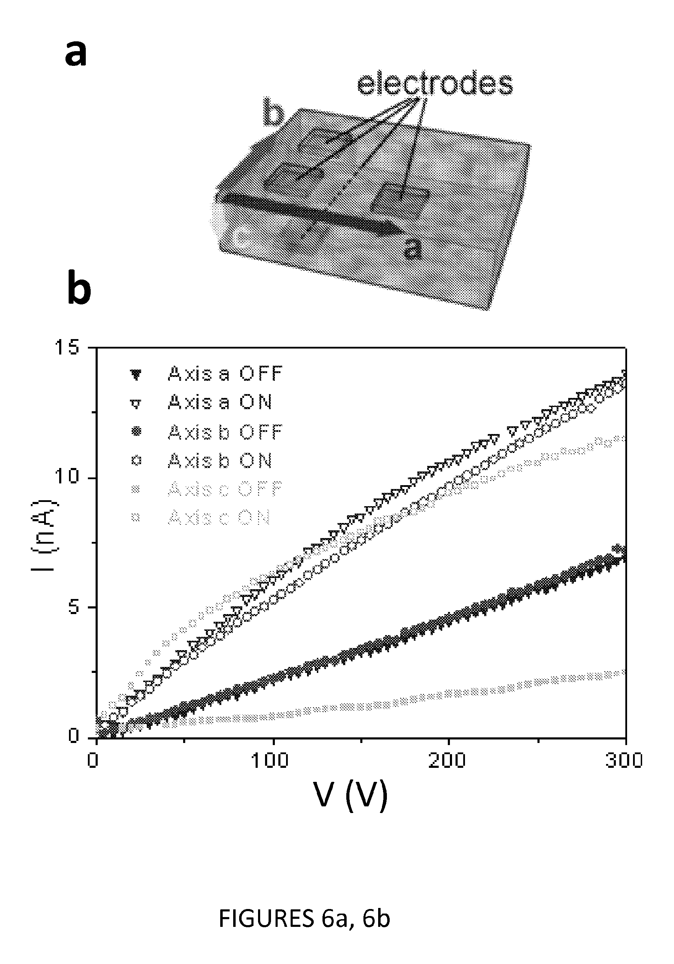

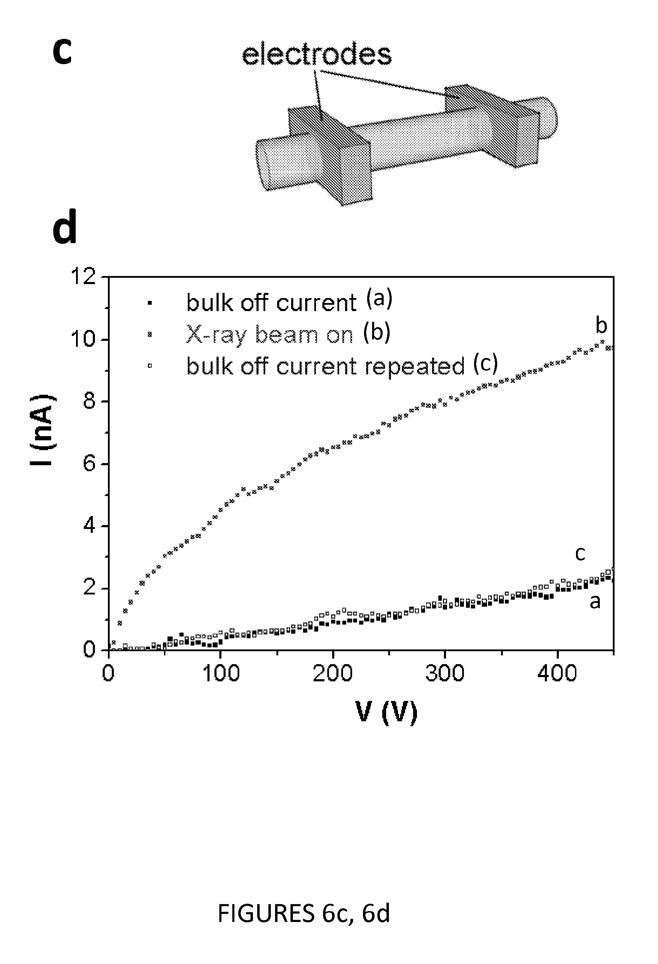

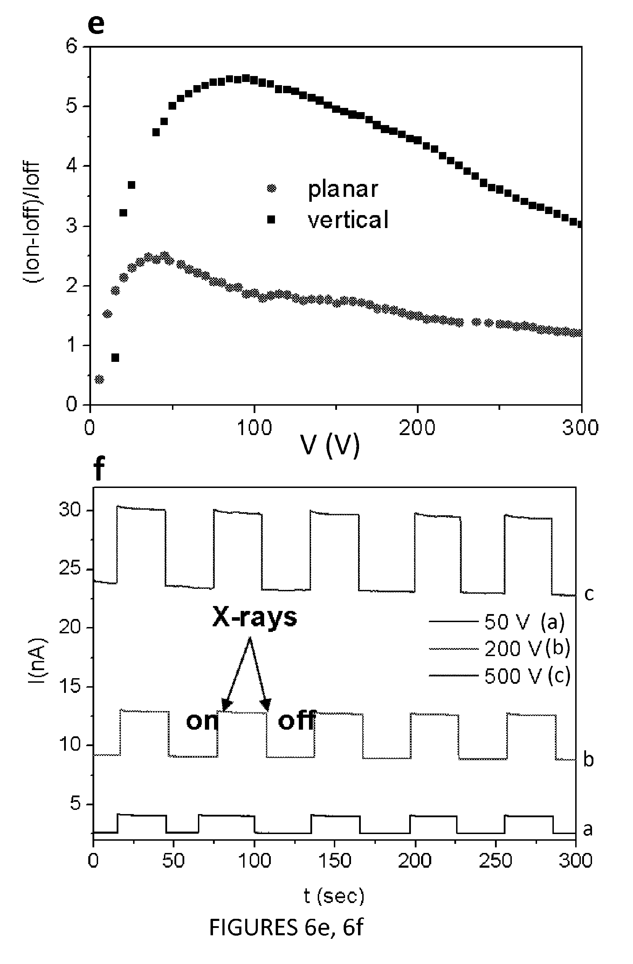

Figure 6 - Device layout and X-rays response. a, b, Schematic layout of the electrical ohmic contacts on a 4HCB crystal along the three crystallographic directions a, b and c (a), and current-voltage curves probed along the three axes with a 35 keV X-ray beam switched on and off (b). c, d, Schematic layout of the electrical ohmic contacts on an NTI crystal (c) and current-voltage curves probed along the crystal main axis with a 35k eV X-ray switched beam on and off (d). Both graphs (b) and (d) have been taken on crystals contacted with shielded Ag electrodes. (e), The comparison between the normalized X-ray induced photocurrents (I_{ON}-I_{OFF})/I_{OFF} along the planar and vertical axes of a 4HCB crystal highlights its anisotropic response and its effectiveness in X-ray detection, already at low voltages. (f) Repeated on-off switching of the X-ray-beam along a planar direction (axis a) of a 4HCB crystal, shown for different applied bias voltages, evidences fast and hysteresis-free response, as well as negligible base current drift. The switching behaviour of NTI crystals is similar to that of the 4HCB crystals, therefore it is not shown.

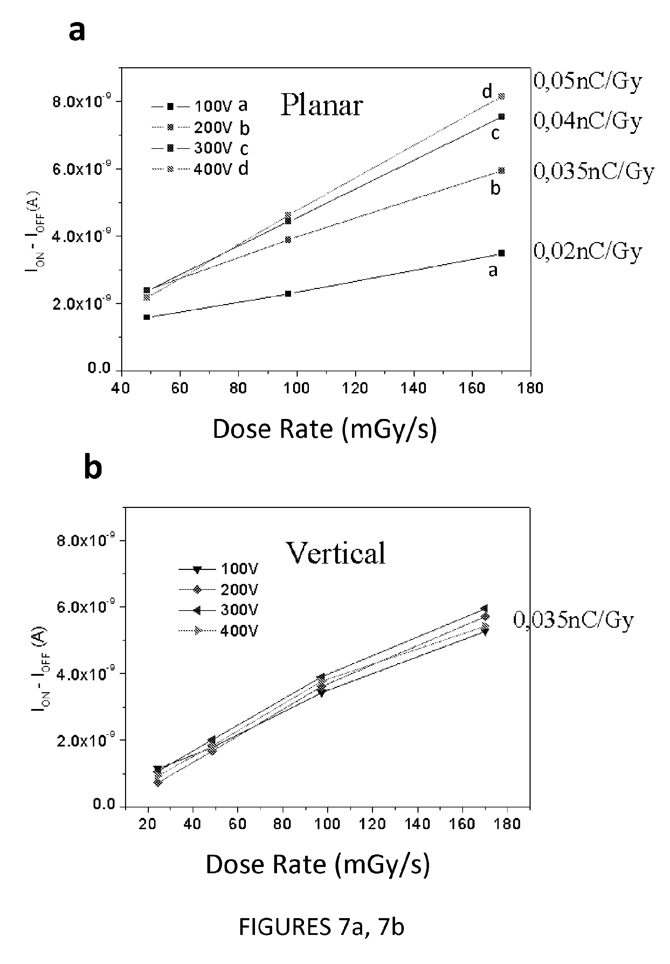

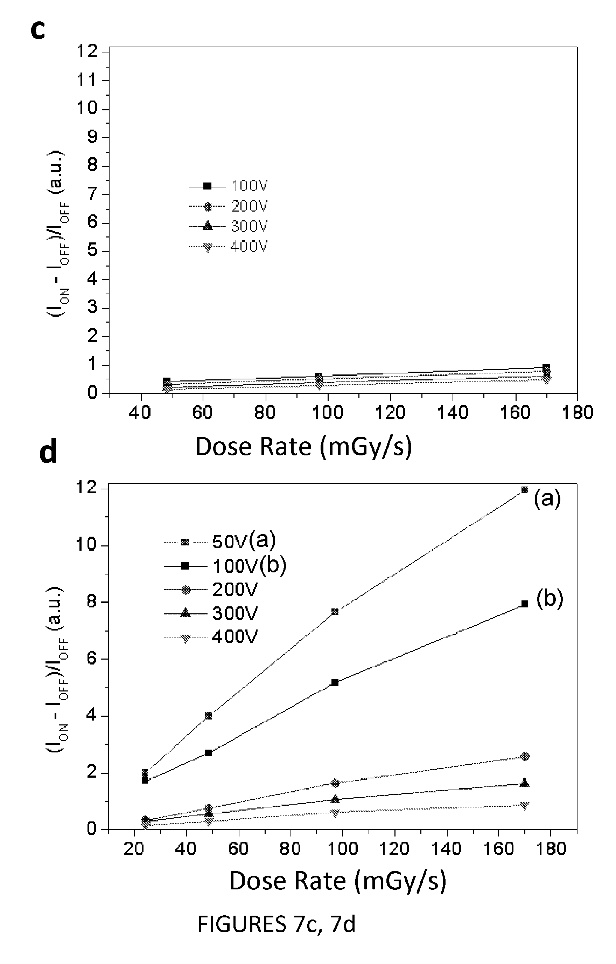

Figure 7 - Response linearity and sensitivity of 4HCB crystals. The X-ray induced current variation ΔI =(I_{ON}-I_{OFF}) at various biases and the relative sensitivities, expressed in nC/Gy (a, b), and the normalized X-ray induced photocurrents ΔI/I_{OFF} (c, d) are reported for increasing dose rates and different biases for the planar and vertical axis, respectively, of a 4HCB crystal. Normalized X-ray induced photocurrents evidence the crystal anisotropic response. All the reported data have been obtained with shielded Ag electrodes on a 4HCB crystal mounted on a quartz substrate.

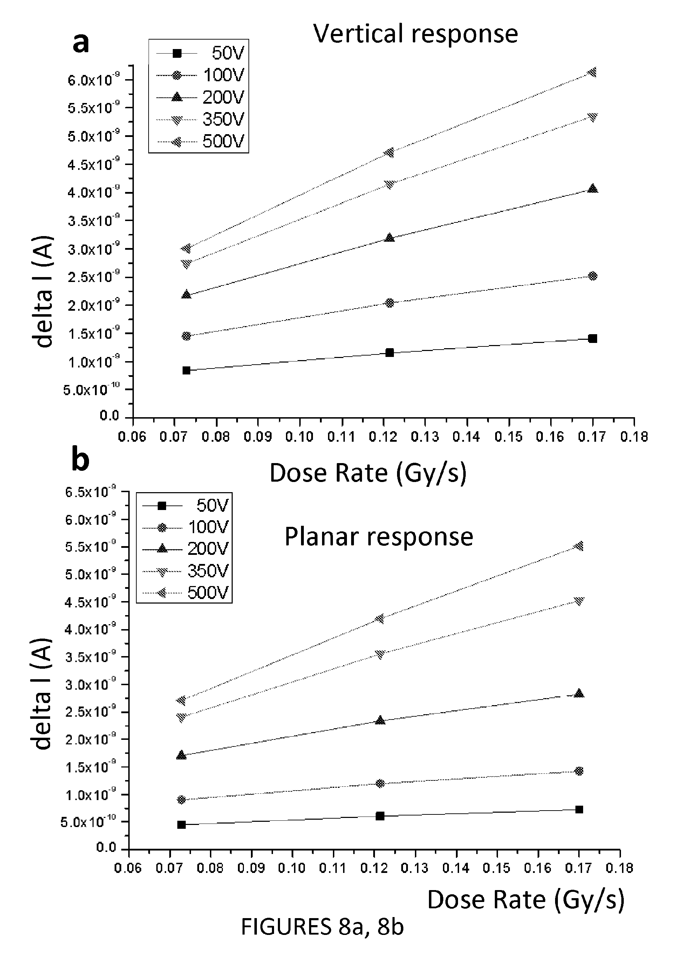

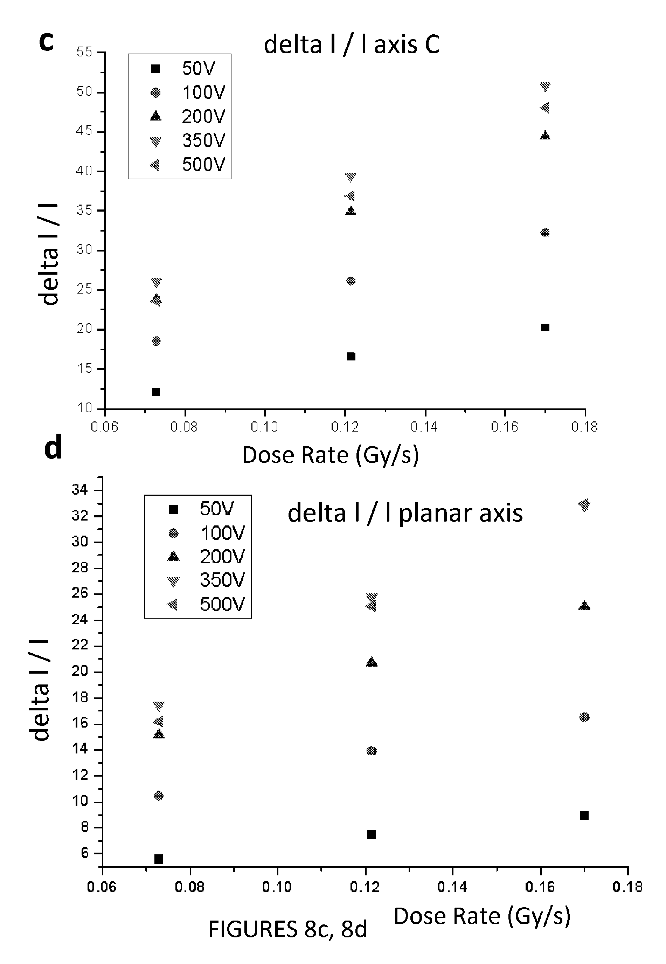

Figure 8 - Response linearity and sensitivity of 4HCB crystals with organic electrodes. a, b, The X-ray induced current variation ΔI = I_{ON}-I_{OFF} are reported for increasing dose rates and different biases for the planar and vertical axis, respectively, of a 4HCB crystal. c,d: The same data of a,b are reported normalized (as ΔI/I) to evidence the response anisotropy. The reported data have been obtained with an all-organic device, with PEDOT:PSS electrodes and on a Polydimethylsiloxane (PDMS) substrate.

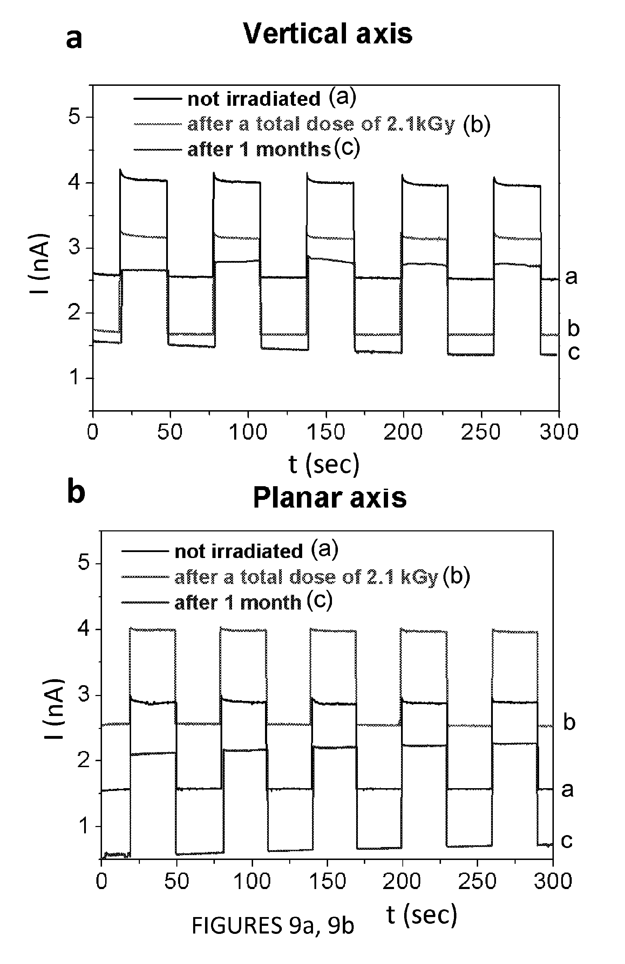

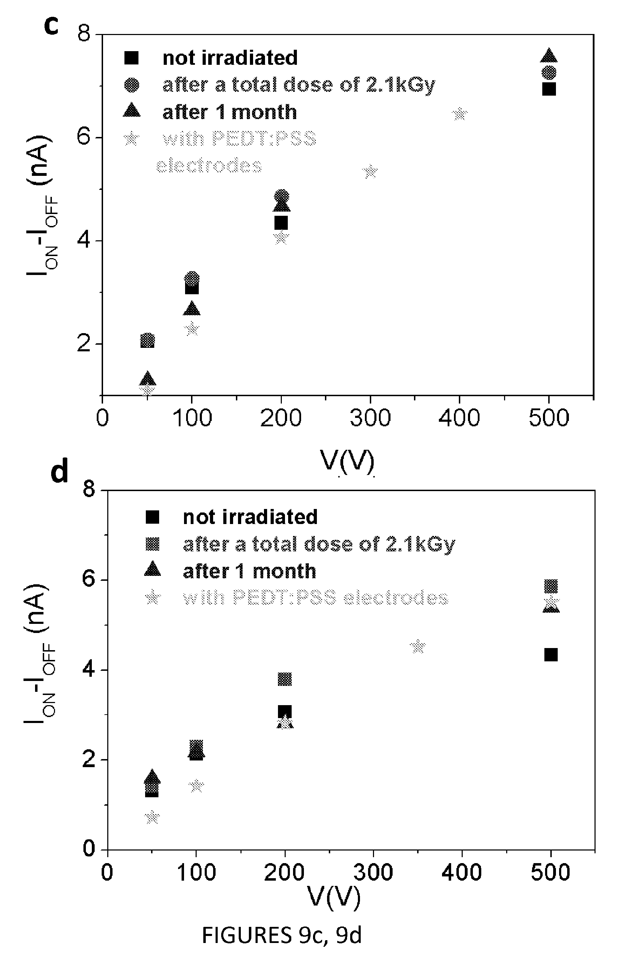

Figure 9 - High X-rays dose exposure and aging behavior of 4HCB crystals a, b, Switching response of a 4HCB crystal with shielded Ag electrodes exposed to an on-off X-ray beam along the vertical and the planar axis ((a) and (b), respectively). The viewgraphs report the current measured before irradiation (dashed line) and after a total X-ray dose of 2.1 kGy (solid line). c, d, The X-ray induced current variation ΔI = (I_{ON}-I_{OFF}) is reported for different bias voltages applied to crystals contacted with either Ag or PEDOT: PSS electrodes in (c) and (d) for the vertical and planar axis, respectively.
Figure 10 - 4HCB crystals act as alpha particle detectors. a) Current-voltage response of a 4HCB crystal before and after exposure to a total dose of 3.7 mGy of alpha particles (open circles), and a total dose of 7.6 mGy of alpha particles (solid triangles) using shielded metallic electrodes. The response of the crystal before irradiation is also reported (black crosses), showing the clear increase in the measured current induced by alpha irradiation. b) the linear response of the detector is shown as a function of increasing alpha dose, at various biases.

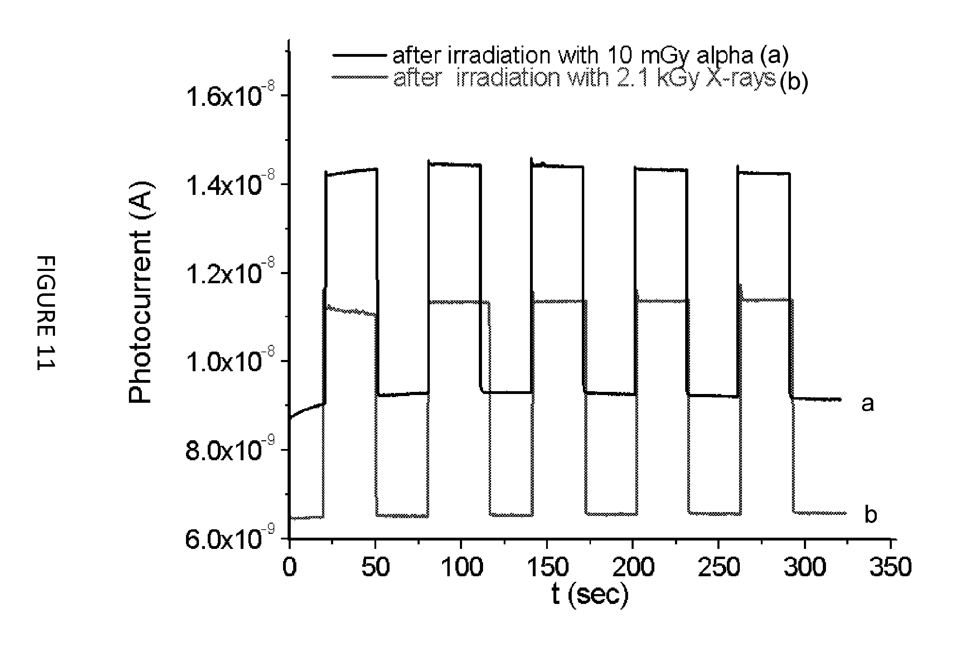

Figure 11 - 4HCB crystals are reliable X-rays detectors even in a radiation hard environment. Switching response of a 4HCB crystal exposed to an on-off 35 keV X-ray beam along the vertical axis, after irradiation with a total dose of 10 mGy of alpha particles (solid line), and after a subsequent further total dose of 2.1 kGy of X-rays (dotted line). As is visible, the ΔI = (I_{ON}-I_{OFF}) does not vary even after the exposition of the crystal to such high doses of different ionizing radiations. The device was fabricated on Cu with Ag electrodes.

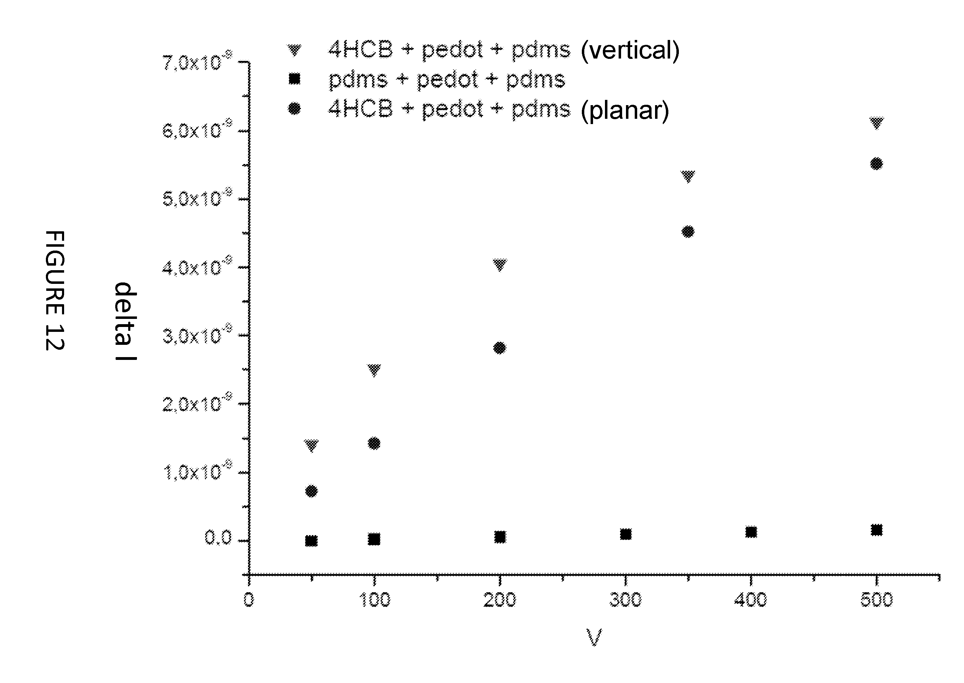

Figure 12 - Electrical response Delta I (I_{ON}-I_{OFF}) under X ray irradiation of a complete all-organic device (4HCB+PEDOT:PSS+PDMS) in vertical and planar configuration, compared with the electrical response of the complete device structure without the active 4HCB organic crystal.

With reference to Figure 1, panel a) and panel b) show respectively how different is the working of a simple, direct detector based on an organic semiconductor, which is outside the scope of the present invention and an intrinsic, direct detector based on an organic semiconductor, which is within the scope of the present invention. According to panel a) an ionizing radiation hits the metallic electrode, which, subsequently to the interaction with said radiation, emits a secondary electron, which on its part interacts with the organic semiconductor. Charge carriers are generated within the organic semiconductor, which are then collected to the counter electrode, and the so generated electric current is measured in the electric circuit. According to panel b), the ionizing radiation hits the organic semiconductor, wherein, subsequently with the interaction with said ionizing radiation, charge carriers are generated and collected to the counter electrode and the generated electric current is measured in the electric circuit.

In order to demonstrate that the detector according to the present invention is an intrinsic, direct detector for ionizing radiations, specific experiments have been carried out.

Referring to Figures 2 and 3, a first detector using the semiconductor organic material according to the present invention was built. Figure 2a shows a detecting element (A), composed of said organic material, metallic pads (C) acting as metal electrodes and metallic wires (B) connecting the detector to a measuring circuit (not shown). Figure 2b shows the same assembly, except that the metallic pads (C) are shielded from the incident ionizing radiation (an exemplary X beam in the Figure). Turning now to Figure 3, herein shown for an exemplary embodiment of an intrinsic, direct detector made of 4HCB single crystal, it can be appreciated that if metal electrodes (pads) are directly exposed to X-rays, they can output an electric signal, even without organic crystal, although they signal is anyway lower than the signal obtained with the crystal. When the metal contacts (pads) are shielded, this effect is almost completely eliminated. This finding confirms the inventors' finding that the state of the art direct detectors based on organic semiconductors, having metal electrodes (pads) exposed to the ionizing radiation, are "simple, direct detectors" and not "intrinsic, direct detectors" as the ones disclosed in the present invention. The details are shown in Example 7, for one exemplary embodiment of the present invention, however the results presented in this example can be validly extended to the whole breadth of the invention herein disclosed.

Analogously, with reference to Figure 4, here shown for an exemplary embodiment of a detector made of a 4HCB single crystal exposed to X-ray radiation, the present invention demonstrates that if metallic pads are directly exposed to the ionizing radiation, the detector response is somewhat "doped", by the interaction of the metallic pad with the ionizing radiation. Using organic electrodes in an intrinsic, direct detector made of organic semiconductor according to the present invention, the obtained response is comparable to that of a detector using shielded metal pads. The reason is that organic electrodes emit considerably less secondary electrons than metallic/semimetalic electrodes upon interaction with ionizing radiations. This demonstrates the intrinsic response of the detector of the present invention. This discussion is explained in more details in Example 7.

The detectors according to the present invention show advantageous anisotropic properties, as shown in the exemplary embodiment in Figure 6 and Example 9.

Another advantageous property of the detectors provided by the present invention is their response linearity. As shown in the exemplary embodiment of Figure 7, the linear response is exhibited also with shielded metallic pads. Response anisotropy between planar and vertical axes is also shown. Further details are given in Example 8. The same linear and anisotropic response is shown with organic pads, as depicted in Figure 8 and in more detail in Example 11. The ensemble of Figures 3, 4 and 5, 8 and 9 demonstrates that the detectors disclosed in the present invention are intrinsic, direct detectors for ionizing radiations. Figure 9 provides evidence of reproducible response in time, both with metal and organic pads. No hysteresis after repeated on-off cycles affects the performance of the detector of the invention, which shows to be reliable even after one month of working and also in heavy working conditions. Details are given in Example 12.

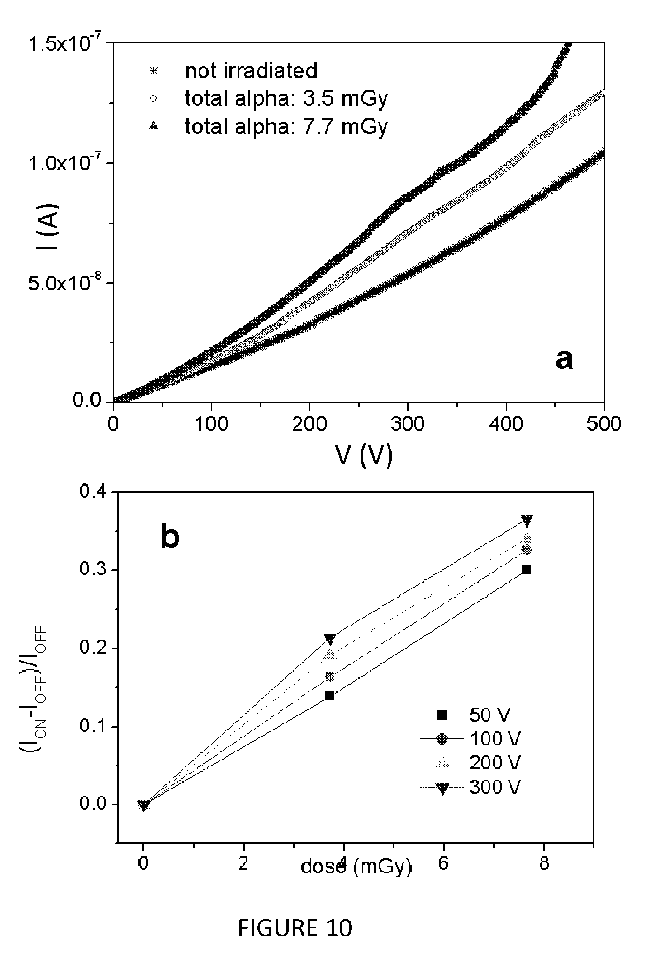

Reliability of the detector of the present invention is shown also in another exemplary embodiment with alpha particles (Figure 10, Example 13). The detector is reliable even in radiation-hard conditions, for example after exposure both to X-ray and alpha particles, as shown in Figure 11 and Example 14.

A further advantage is the very low dark current, as proved in Figure 12.

It has to be understood that all the reference to the Figures are to exemplary embodiments and non-limiting examples. The skilled person can easily appreciate that the herein described properties are general to all the intrinsic, direct detectors for ionizing radiations made of organic semiconductors according to the present invention.

According to the present invention, the organic semiconductor may include a number of different possible chemical groups, for example the groups consisting of ortho- or meta- or para- disubstituted benzenes (as for example 4-hydroxycyanobenzene, and the like), condensed aromatic hydrocarbons (as 1,8 naphtalenediimide, or 2,4-dinitronaphthalen-1-ol, or 9,10-anthracenedicarboxylic acid, or 3,4-dihydroxy-9,10-dioxo-2-anthracenesulfonic acid sodium salt (also named alizarin red S), or the like), azobenzenes (as azobenzene, 2-(4-dimethylaminophenylazo)benzoic acid (also named methyl red) and the like), conjugated molecules (as for example β-carotene, and the like), and that may form a solid state assembly (like a single or a polycrystal) upon solvent/solvents mixture evaporation, or spontaneous solidification (like crystallization). A complete list of the possible organic semiconductors may be found in "Organic Electronic Materials - Conjugated Polymers and Low Molecular Weight Organic Solids", Springer Series in Materials Science, Vol. 41, Farchioni, R.; Grosso, G. (Eds.), 2001, Springer-Verlag Berlin. These groups of molecules have been selected since they possess quite different molecular structures and packing arrangements, thus allowing to more clearly highlight and assess how the here described properties are common to many different groups of organic semiconductors.

In a preferred embodiment of the present invention, said intrinsic, direct detector is made of an organic single crystal or a polycrystal.

In a preferred embodiment of the present invention, the detector is made of a semiconducting single crystal or polycrystal consisting of 4-hydroxycyanobenzene or 1,8-naphthalenediimide.

In an embodiment of the invention, the detector may comprise at least one electrode made of ultrathin (approximately less than 1 micrometer thick) metal or semimetal, in the form of plain layers or as patterns defined with any means; also a plurality of other different inorganic materials (like for example doped inorganic semiconductors, ceramic-based conductors, conducting oxides, and the like), are contemplated as possible electrode constituting material, provided that they have a thickness lower than that needed for interacting appreciably with the incoming ionizing radiation, said electrode having a thickness not larger than 1 micron. The person skilled in the art will know that the exact thickness of the layer will vary depending on the absorption coefficient of the material with respect to the ionizing radiation, and that this thickness can be easily calculated (see e.g. http://www.nist.gov/pml/data/xcom/index.cfm).

Any metal or semimetal suitable for the purpose of creating electric contacts in the form of electrode can be used. The person of ordinary skill in the art can select the suitable metal for the specific purpose. According to Mendeleev's Table, alkali metals are Li, Na, K, Cs, Rb, Fr (Group IA). Alkali-earth metals are Be, Mg, Ca, Sr, Ba, Ra (Group IIA). Inner transition metals (Lanthanides and Actinides) are Sc, Y, La, Ce, Pr, Nd, Pm, Sm, Eu, Gd, Tb, Dy, Ho, Er, Tm, Yb, Lu, Ac, Th, Pa, U, Np, Pu, Am, Cm, Bk, Cf, Es, Fm, Md, No, Lr (Group IIIA and Lanthanoids and Actinoids). Transition metals are Ti, Zr, Hf (Group IVA), V, Nb, Ta (Group VA), Cr, Mo, W (Group VIA), Fe, Co, Ni, Ru, Rh, Pd, Os, Ir, Pt (Group VIIIA), Cu, Ag, Au (Group IB), Cd, Cd, Hg (Group IIB). Metals are Al, Ga, In, TI (Group IIIB), Sn, Pb (Group IVB). Semi-metals, metalloids are Si, Ge, As, Sb, Te, Po. Preferred metal or semimetal for the ultrathin electrode may be selected from the group consisting of Gold (Au), Silver (Ag), Copper (Cu), Aluminium (Al), Iron (Fe), Titanium (Ti), Nickel (Ni), doped Silicon (Si). Conductive and semiconductive compounds and alloys of the above listed elements are also comprised in the purpose of the present invention, once they are known be suitable as electrode material, as for example Indium-Tin Oxide, Fluorine-Tin Oxide, and the like.

In a further embodiment of the invention, the detector comprises at least one organic electrode. The organic electrode may comprise conducting polymer blends, conducting polymers, doped semiconducting polymers and/or molecules, carbon nanotubes, fullerene and/or its derivatives, graphite, graphene and/or its derivatives (for example graphene oxide), organic conducting charge-transfer salts, in the form of plain layers or as patterns defined with any means.

Preferred materials for organic electrodes are for example PEDOT:PSS, polyaniline, doped derivatives of poly(paraphenylene-vinylene), doped poly(3-hexylthiophene), fullerene derivatives, carbon nanotubes, graphene, graphene oxide.

In another embodiment of the present invention, the detector comprises multiple different organic semiconductors, which can be the same or different and which are integrated onto a single substrate

According to a further aspect of the invention, it is provided a method for manufacturing an intrinsic, direct detector for ionizing radiations based on organic semiconductors.

For the growth of organic semiconductors on a substrate, many different known methods may be employed.

A first method according to the present invention comprises:
a. deposing a solution of an organic semiconductor on a substrate;
b. evaporating said solution;
c. providing the obtained organic semiconductor with electrodes and/or electrical circuits.

A second method according to the present invention comprises:
a. growing an organic semiconductor from a solution thereof;
b. evaporating said solution;
c. deposing said organic semiconductor on a substrate;
d. providing said organic semiconductor with electrodes and/or electrical circuits.

Here, methods for the growth of mono/single or polycrystals (in the following, simply "crystals") are described.

As exemplary embodiment of the present invention, methods for solution-grown organic single crystals and organic polycrystals are provided. However, it is intended that the invention is not limited to this embodiment, since the teaching can be easily extended to the whole breadth of the invention.

Generally, the methods of the present invention comprises dissolving an organic compound to be crystallized in a proper volume of a solvent or mixture of solvents. The solution obtained is optionally filtered for eliminating undesired particles and then poured in a vessel. Evaporation of the solvent is performed in a thermostatically controlled environment at a desired evaporation rate so as to allow the formation of the organic semiconducting crystal. The evaporation rate of the solvent/mix of solvents, is controlled by adjusting the temperature and the pressure of the system, or by adjusting the vapour escapes holes diameters. These adjustments are made for keeping the evaporation rate to a value apt to assure a regular formation of the crystal structure, i.e. the pattern of the crystal, so as to obtain crystals free of defects. The evaporation rate may also be maximized by deposing the solution directly on the substrate with no closed vessel o surfaces limiting the evaporation rate. In this case a single crystal, or a polycrystal, or a film, or fibers or other structures made of the organic semiconductor, may be formed.

In another embodiment, the organic semiconductor can be solution grown onto a proper substrate. For example, on the bottom of a vessel, a substrate provided with electrical conductor patterns suitable for assuring the operation of the final device is provided. The patterns may be constituted by ultrathin metal layers, or by organic conductors.

The method may also include the deposition (or, in other terms, printing) of the said solution on a substrate, that may be patterned with conductive electrodes, by means of any technique able to deliver a solution onto a substrate with precision in terms of position of delivery and amount of delivered solution, as for example inkjet printing, spray coating, drop casting, pad printing, dip coating, doctor blading and the like. These techniques are thoroughly described in "Handbook of Print Media Technologies and Production Methods", Helmut Kipphan (Ed.), Springer-Verlag Berlin Heidelberg 2001.

The solvent may be selected from the group consisting of ethers (acyclic, as for example ethyl ether, methylethyl ether, or isopropylethyl ether and the like, or cyclic, as tetrahydrofurane, 1,4-dioxane, and the like), hydrocarbons (acyclic aliphatic, as petroleum ether, heptane, and the like, or cyclic aliphatic, as cyclohexane, cyclopentane, and the like, as well as aromatic, as toluene, ethylbenzene and the like), alcohols (either acyclic, as ethanol, isopropanol and the like, or cyclic, cyclopentanol, cyclobutanol and the like), ketones (acyclic, as acetone and the like, or cyclic, as cyclohexanone and the like), carboxylic acids (acetic acid, formic acid and the like), anhydrides (as acetic anhydride and the like), nitriles (as acetonitrile and the like), halogenated solvents (as chloroform, trichloroethylene, and the like), water. A full list of the possible solvents is contained in "Handbook of organic solvent properties", Ed. Ian M. Smallwood, 1996, Arnold. Any combination of two or more of the above cited and/or considered solvents can also be used. The solvent/solvents mixture is chosen so to not damage components or parts of the equipment used for the solution deposition.

The solvent is selected according to the general knowledge in this field, namely according to the chemical nature of the organic semiconductor and to the desired final solid form (either single crystal, polycrystal, film, fibers or other structures). An additional criterion in the selection of the solvent is that it should not damage materials like glass, plastic foils or other substances that can be used as substrates for the crystal growth.

Preferably, the concentration of the organic material from which the crystals have to be produced into the solvent (or solvent mixture) is comprised between 1 and 30 mg/l, more preferably between 3 and 20 mg/l.

Preferably, the evaporation may be carried out also at a controlled pressure and temperature.

According to a further embodiment of the method of manufacturing the detector disclosed in the present invention, the organic semiconductor is solution-grown on a patterned substrate, thus providing the detector with the suitable electrical circuit or at least the electrical contacts for the connections with the electrical circuit. The substrate may be cooled in order to lower the solvent/solvents mixture evaporation ratio, by means of suitable means, as for example Peltier cells, cold fingers, or the like. The cooling may be, or be not, coupled to the use of a closed vessel for controlling the evaporation rate. The substrate may be placed into a vessel closed with a lid allowing to control the evaporation ratio. The evaporation rate of the solvent/mix of solvents can be chosen in order to assure the complete evaporation of the solvent in maximum 48 hours. More preferably, the evaporation rate can be chosen in order to obtain the complete evaporation of the solvent in maximum 24 hours. Preferably, the controlled pressure is equal to the environmental pressure, less preferably the controlled pressure is slightly below than the environmental pressure, or slightly higher than the environmental pressure. In other embodiments, it is possible to control the temperature instead of the pressure of the place where the controlled evaporation takes place, or viceversa. The substrate covered by crystals is then removed from the vessel.

In a further embodiment of the present invention, the substrate may be treated with chemical or physical treatments allowing the organic semiconductor to be crystallized in correspondence of existing electrodes, as the skilled in the art will understand. The above mentioned treatments may comprise plasma treatments, under vacuum or in presence of any desired gas, UV-light treatments under vacuum or in presence of any desired gas, mechanical abrasion or polishing, chemical acid or basic etching, self-assembled monolayers deposition.

An alternative method for the growth of crystals directly on the patterned substrates comprises depositing a drop of a solution, any one of the solutions above described, directly onto the substrate, being this patterned or not. Preferably in this case a solvent, or a mix of solvents, has a boiling temperature higher than 30°C, or more preferably higher than 40°C.

Quite unexpectedly, the detector according to the present invention works even with organic contacts, contrary to the expectation of the prior art, as discussed above.

Using an organic electrode, a further advantage is envisaged that the process of production is easier and cheaper.

Moreover, the use of an organic electrode allows a flexible and/or transparent detector, thus obtaining a detector capable of adapting to a curved or irregular surface, or a see-through detector, or a detector having both the mentioned properties. Moreover a transparent and/or flexible substrate may be used. Therefore, the detector according to the present invention can be provided in a flexible form and/or can be optically transparent.

The solution-grown organic semiconductors according to the present invention are size-tunable in side (from 10 microns up to few mm) and thickness (from about 10 microns up to about 4 mm).

The intrinsic, direct detectors of the invention can be endowed with stable and reproducible anisotropic electronic transport properties.

The intrinsic, direct detectors of the invention are reliable and reproducible detectors, and are capable to be operated at room temperature and in environmental conditions (i.e., at atmospheric pressure and composition, and under natural or artificial light), though they can be also operated in environmentally controlled conditions (as for example in controlled atmosphere, or at controlled temperature higher or lower than the room one).

According to the present invention, the organic semiconductors can be used as intrinsic, direct detectors for different kinds of ionizing radiation and particles. For example, they can be used for the detection of X-rays and alpha-particles, but also for gamma radiation and neutron radiation, and have been demonstrated capable of intrinsic, direct detection of the ionizing radiation with high sensitivity.

In a preferred embodiment of the present invention, the intrinsic, direct detector is based on 4-hydroxycyanobenzene (4HCB) or on 1,8 naphthalenediimide (NTI) single crystals, or on 4HCB polycrystals, and have shown high direct X-rays-to-current conversion efficiencies.

The organic semiconductor-based intrinsic, direct detectors of the invention operate in air, under ambient light and at room temperature, thus they do not require special operating condition and reduce operating costs.

Moreover, the results obtained with the organic semiconductor-based intrinsic, direct detectors of the invention are well reproducible over multiple samples. Thus, very reliable detectors are obtained.

Moreover, the organic semiconductor-based intrinsic, direct detectors of the invention have a linear response, thus can be easily used to provide quantitative information on the detected radiation dose, without requiring additional calibration actions in the correlation between the input and output signal.

The organic semiconductor-based intrinsic, direct detectors of the invention can be easily fabricated on a large mass production scale, maintaining their peculiar low fabrication cost.

By properly choosing the organic semiconductor, it is possible to obtain different intrinsic, direct detectors optimised for the detection of the ionizing radiations in a particular wavelength range. The person of ordinary skill in the art of detectors for ionizing radiations can easily make this selection within the range of organic semiconductors disclosed above, or selecting another organic semiconductor without exercising inventive skill.

For example, organometallic-based molecules like boron-containing molecules, phosphorus-containing molecules, silicon-containing molecules, germanium-containing molecules, and the like, may be used. A more complete, though not exhaustive list of the organometallic molecules that may be used for growing the organic semiconductor, is contained in "Organometallic Chemistry and Catalysis", by Didier Astruc (Ed), Springer Verlag Berlin Heidelberg 2007, whose content is here incorporated in its entirety by reference.

Even multiple, different organic semiconductors may be mounted or grown onto a single substrate, so to realize a detector sensitive to different energies of the ionizing radiation, or to different ionizing radiations, within a single device.

In this way, the organic semiconductor-based intrinsic, direct detectors of the invention allow the detection of different kind of radiation at the same time and on the same device, for example alpha- and X-radiation, alpha- and neutron-radiation, and the like.

The present invention finds advantageous application in the manufacturing of detectors for X-rays, or generally radiation apparatuses (also intended as radiographic instruments or radiation devices), to be used for medical investigation, for security check for example in airports, for detecting radioactive contamination, or radioactive leaks, or also in the manufacturing for control apparatuses to be used in industrial facilities for checking the quality of the products, and the like.

The present invention finds advantageous application in the manufacturing of radiation devices, for example of sterilising apparatuses for beverages, medical devices, and the like, or also of scientific instrument such as in tomography, crystallography, and the like.

The anisotropy in the detection response found in single crystals grown out of organic semiconductors allows to fabricate intrinsic, direct detectors capable of identifying the direction from which the radiation is coming. In this connection, a particular preferred embodiment of the present invention provides a detector, wherein the organic semiconductor is a 4-hydroxycyanobenzene (4HCB) single crystal and wherein multiple electrodes are positioned on said crystal, with a geometrical layout allowing the detection of a two-dimensional or three-dimensional anisotropic response to an ionizing radiation to which the crystal is exposed. The geometrical layout can be determined by the person skilled in the art.

### Description of the preferred embodiments

In a preferred embodiment the organic semiconductor is a single crystal.

In another preferred embodiment, the organic semiconductor is a polycrystal.

In a first preferred embodiment, 4-hydroxycyanobenzene (4HCB) is used as the organic semiconductor. With this material, a preferred solvent is ethyl ether, another preferred solvent is toluene, a further preferred solvent mixture is ethyl ether:petroleum ether (60°C) 9:1 v/v, in a still preferred formulation a mix of solvent, for example ethyl ether:toluene 9.5:0.5 may be used, another one is ethyl ether:tetrahydrofurane:toluene 0.5:0.45:0.05 v/v. It shall be noted that the here defined ratios between different solvents are only indicative, and may vary according to the chosen growth conditions (temperature, pressure), and to the chosen organic semiconductor, as the skilled in the art will recognize. Other solvents or mix of solvents may also be used depending on the geometrical features (length, width, thickness) of the crystals to be obtained, as the skilled in the art will understand.

For an exemplary embodiment of 4HCB, preferably, the temperature of the thermostatically controlled environment is below 25°C, more preferably below 10°C. Conditions for other organic semiconductors for use in the manufacture of intrinsic, direct detector according the present invention can be determined by the skilled person just taking into consideration the well-known physico-chemical properties of said organic semiconductors, such as for example solubility or insolubility in the appropriate solvent, evaporation rate of the solvent or mixture of solvent used at the growth temeprature and pressure.

The following examples further illustrate the invention.

### Electrical measurements

All the electrical measurements reported here have been carried out at room temperature, under ambient light and in air using a Keithley Source-Meters 2400 and Electrometers 6175A. The ohmic contacts on 4HCB were fabricated either using a silver-based epoxy (Epo-Tek E415G) or by PEDOT:PSS via a PDMS stamp-printing process

### X-ray and alpha particle irradiation

All the measurements have been carried out in open atmosphere and at room temperature. We have employed an X-ray tube with Mo anode operated at 35 kV with current varying from 5mA to 35 mA to induce a constant X-ray dose rate varying between 24 and 170 mGy/s.

For X-rays, the dose rate in air of 4HCB single crystals, given their absorption cross section, translates into a dose rate of D=170(15) mGy/s (at 35 mA), therefore it can be estimated that about 5% of the impinging photons are absorbed within a typical crystal thickness of 600 µm.

Alpha particle irradiation has been performed using a ²⁴¹Am source (5.4MeV) that delivers an average dose of 0.4 µGy/s.

### Example 1. Preparation of solution-grown single crystals of 4HCB on patterned substrate

In a preparation, about 40 mg of 4HCB have been dissolved in about 10 ml of ethyl ether. The obtained solution is filtered and poured in a beaker, on the bottom of which a patterned substrate with conductive traces is positioned. The beaker is then closed with a suitable lid, and then the closed beaker is positioned in a thermostatic room at 6°C. After 48 hours the solvent is completely evaporated and the substrate is covered by crystals of 4HCB.

The beaker is removed form the thermostatic room, the substrate covered by the crystals of 4HCB is removed form the beaker. The obtained crystals, already electrically contacted via the conductive patterns previously defined on the substrate, are used to form active devices.

### Example 2. Preparation of solution-grown single crystals of 4HCB

In a further preparation, about 40 mg of 4HCB have been dissolved in 10 mL of a mix of ethyl ether/toluene 9.5:0.5 v/v, the obtained solution is treated as disclosed in Example 1.

### Example 3. Preparation of solution-grown single crystals of 4HCB

In a further preparation, about 40 mg of 4HCB have been dissolved in 10 mL of a mix ether:tetrahydrofurane:toluene 0.5:0.45:0.05 V/V. The obtained solution is then treated as disclosed in Example 1.

### Example 4. Preparation of solution-grown polycrystals of 4HCB

In a further preparation, a 4HCB (40 mg) solution in ether (10 mL) is deposed by means of a micropipette onto a substrate patterned with conductive traces, at room temperature and environmental pressure. The obtained polycrystals, already electrically contacted via the conductive patterns previously defined on the substrate, are used to form active devices.

### Example 5 Preparation of solution-grown single crystals of NTI

The fabrication of NTI crystals was carried out dissolving 20 mg of as-purchased NTI powder (Aldrich) in 30 mL of CHCl₃. The solution was deposed in a 250 mL beaker, and the beaker was covered with a suitable lid and left under a hood for 48 h, during which the solvent evaporated completely. After that, the needle-like crystals were removed from the bottom of the beaker with a spatula.

### Example 6. Preparation of solution-grown, self standing single crystals of 4HCB from pre-purified crystals

In a typical preparation, pre-purified (A. Fraleoni-Morgera et al., J. Crystal Growth 2010, 312, 3466) 4HCB crystals (30 mg) were dissolved in 10 mL of ethyl ether (high purity degree) in a 250 mL beaker, which was covered with aluminium foil and put in a vented fridge at 6 °C to allow a slow solvent evaporation, which was completed within 48 h. The so-obtained single crystals were then recovered by gently removing them from the beaker bottom with a spatula..

### Example 7 - Assessment of the intrinsicity of the response of the organic semiconductor, and of the linearity of this response.

The response of detectors based on 4HCB single crystals mounted with the setups shown in Figure 2 was measured.

When the device has non-shielded metallic electrodes (setup as in Figure 2a) the response is higher (Figure 3a), reaching about 8.5 nA. Moreover, the response of the devices with shielded metallic electrodes (setup as in Figure 2b) and with organic conductive electrodes is well comparable, reaching at maximum 7 nA (figs 3b and 3c, respectively). These findings are verified at each of the tested biases, and the comparison between the three measured responses shows clearly that devices with non-shielded metallic electrodes always present currents at least 20% higher than those having shielded metallic electrodes, or organic electrodes, therefore pointing to a strong concurrence of the metallic electrodes (or substrates, since 4HCB crystals deposed on metallic substrates delivered the same currents observed for crystals contacted with non-shielded metallic electrodes and deposed on quartz substrates) to the device response.

Figure 4 shows the electrical response Delta I (I_{ON}-I_{OFF}) under X ray irradiation of a device constituted as in Figure 2, but without the organic semiconducting detecting element A. The response is reported for electrodes connected with Cu wires and 3-dimensional (3D) W tip probes placed either directly under the X-ray beam or shielded from it. It is evident how directly exposing metal contacts to an X-ray beam in air induces the readout of an electrical signal, even when the detecting element A of Figure 2a is substituted by quartz. Since quartz is a material known to be a complete electrical insulator, it cannot be the source of the current detected by the device under X-rays irradiation evidenced in the figure (curves with full red squares and empty red triangles), which has hence to be originated from other sources. On the other hand, always using a quartz slide as the detecting element A, but with the setup of Figure 2b (i.e. shielding the electrodes/3D tips from the X-rays), negligible currents are recorded. This indicates clearly that the origin of the currents detected in the previous experiment is the irradiation of the metallic electrodes with X-rays, which is likely to produce air ionization via secondary photoelectrons deriving from the photoelectric effect of X-rays on metals. This effect is marked when the electrodes B are constituted by 3D tungsten (W) tips, less marked but still evident when the metal wires are constituted by simple 2-dimensional copper (Cu) electrodes, because of the larger surface exposed to X-rays of 3D tips with respect to 2D electrodes. Interestingly, the amount of the current detected when the metallic electrodes are not shielded (about 1-2 nA) is well comparable to the difference between the current detected for a complete (i.e. using the organic semiconductor 4HCB single crystal) device with non-shielded metallic electrodes, Figure 3a, and the currents detected for complete devices with shielded metallic electrodes, or organic electrodes (Figure 3b,c, respectively).

From the above described experiments it is clear that the response of the organic semiconductors 4HCB single crystal is intrinsic. It is also evident that metallic electrodes applied to the organic semiconductor hit by an ionizing radiation can contribute strongly to the final device response, with the amount of the contribution depending on the type and geometry/shape of the electrodes. This introduces a considerable uncertainty over the detection response of an organic semiconductor-based direct detector using metallic contacts, unless the latter are accurately positioned so to avoid direct exposure of the metallic electrodes to the ionizing radiations, or they are ultrathin (approximately < 1 micron), so to not interact appreciably with the incoming radiation.

### Example 8 - Response of an ionizing radiation detector fabricated with a 4HCB crystal and metal electrodes, on a quartz substrate

4HCB single crystals were put on a quartz substrate, and contacted with metallic electrodes properly shielded in order to screen them from the x-ray beam (as in Figure 2b), and irradiated with a 35 kV X-rays dose. In these conditions the bulk currents, I_{OFF}, measured along the two planar axes a and *b* are comparable and, therefore, we will refer in the following only to the "vertical" and the "planar" axes, without distinguishing between axis *a* and *b.*

The X-ray induced current variation ΔI =(I_{ON}-I_{OFF}) (a, b) and the normalized X-ray induced photocurrents ΔI/I_{OFF} (c, d) are reported in Figure 7 for increasing dose rates and different biases for the planar and vertical axis, respectively, of a 4HCB crystal. Normalized X-ray-induced photocurrents evidence the crystal anisotropic response.

Figures 7 and 8 show the photocurrent values ΔI = (I_{ON} - I_{OFF}) along the planar and vertical directions at different voltages and for dose rates ranging from 24 mGy/s up to 170 mGy/s for devices with either metal or organic electrodes. Two noteworthy properties that can be evinced for both axes are i) the linear response of the crystal for an increasing X-ray dose rate at each tested bias and ii) the possibility to drive the device at bias voltages as low as 50 V.

The sensitivity of the material, defined as S=(I_{ON}-I_{OFF})/(Dose rate), reported in Figure 7a, is 0.05 nC/mGy at 400V, i.e. only three times smaller than that of Silicon detectors (about 0.14 nC/mGy). In particular, anisotropic transport in crystals has been measured using different contact configurations, namely silver epoxy and PEDOT:PSS. PEDOT:PSS was deposited by means of a micro-contact printing technique and, thanks to the lower measured bulk current, it allows increasing of a factor 3 the relative sensitivity of the devices with respect to devices fabricated with metal electrodes (see figures 7 and 8).

### Example 9 - Ionizing radiation detectors fabricated using the organic semiconductor 4HCB on Cu substrates.

The layout of X-ray intrinsic, direct detector based on the organic semiconductor 4HCB is depicted in Figure 6a. The effects of X-ray irradiation are shown in Figure 6e in terms of normalized photocurrent, i.e. (Iₒₙ-I_{off})/I_{off}, for the planar and vertical axes.

The recorded photocurrent, measured as a function of voltage, increases significantly and reproducibly when the X-ray beam is on. There is no indication of hysteresis effects when the X-ray beam is repetitively switched on and off, as clearly shown in Figure 6f, that reports the switching behaviour along the planar axes for different bias voltages (identical behaviour is observed for the vertical axis). The extremely fast response time, shorter than 100 ms (instrumental measurement limit) is also noteworthy. In Figure 6c the response to X-ray irradiation of single crystals of 4HCB is shown, and a notable anisotropy in the response is found.

### Example 10 -Ionizing radiation detector fabricated with a NTI crystal on a metal (Cu) substrate

The layout of X-ray intrinsic, direct detector based on the organic semiconductors NTI is depicted in Figure 6b. In Figure 6c the response to X-ray irradiation of single crystals of NTI is shown, evidencing the absence of any visible hysteresis.

### Example 11 - Ionizing radiation detectors fabricated with a4HCB crystal and organic electrodes, on an organic (PDMS) substrate (all-organic device)

The X-ray induced current variation ΔI =(I_{ON}-I_{OFF}) (a, b) and the normalized X-ray induced photocurrents ΔI/I_{OFF} (c, d) are reported in figure 8 for increasing dose rates and different biases for the planar and vertical axis, respectively, of a 4HCB crystal. Normalized X-ray induced photocurrents evidence the crystal anisotropic response. The reported data have been obtained with an all-organic device, with PEDOT:PSS electrodes and on a PDMS substrate. In Figure 8 the response of another device based on 4HCB single crystal, with organic electrodes and on an organic substrate, is reported for different operative biases. As is visible comparing the data with those of Figure 8, the device has a well reproducible anisotropic response. The curve obtained in absence of the 4HCB crystal (black dots), where only the organic electrodes were irradiated with X-rays, testifies that the organic conductive contacts, contrary to the metallic ones, do not origin any relevant signal. In general, the all-organic device architecture increases the degrees of freedom in the design of detectors for ionizing radiations.

### Example 12 - Aging-resistant and anisotropic radiation detectors

In order to assess the radiation hardness of 4HCB crystal under X-rays, we have exposed 10 crystals, prepared according to examples 1 and 2, with comparable electrical transport properties, to a cumulative dose of 2.1kGy and we have then tested their electrical response under an on-off switching X-ray beam (dose rate 170 mGy/s). Figure 9 reports the results obtained before and after the exposure of the same crystal to a total cumulative dose of 2.1kGy, along the vertical (Figure 9a) and the planar (Figure 9b) axes, respectively (the bulk currents I_{off} along the vertical and the planar axes are comparable due to the difference between the contacts size and distance, which is about 200 µm - the crystal thickness - for the vertical axis, and about 700 µm for the planar ones).

Most remarkably, ΔI varies almost linearly for increasing bias voltages along the both axes and it slightly deviates from linearity along the planar ones only at large bias voltages. On the other hand, the ΔI differs more markedly between the two axes as the voltage is increased, confirming the crystals anisotropic behaviour. This observation highlights the crystals anisotropic behaviour. Anisotropy can be a great advantage to develop devices that work independently along more than 1 direction or that "sense" the direction of the incoming radiation beam

### Example 13 - Alpha particle detection

In this example we show the response of as-grown 4HCB crystals to alpha particles from a ²⁴¹Am source (5.4MeV, 3 kBq) delivering an average dose of 0.4 µGy/s.

Figure 10a shows how the current-voltage curves vary by increasing their slope, with increasing total alpha delivered dose along the vertical axis. This result indicates that the electrical response of the crystals can be used to detect alpha particles with a sensitivity of about 4 nA/mGy and is well performing with respect to the possibility of using 4HCB crystals as practical α-rays cumulative dosimeters with a good linear response (figure 10b).

### Example 14 - Radiation hard X-ray detector

In order to assess the device reliability as an X-ray detector in a radiation-hard environment, 4HCB crystals have been alpha-irradiated up to a cumulative dose of 10mGy, and tested under an on-off switching X-ray beam (35kV and 35mA). Their response (Figure 11 (solid line)) shows how alpha-irradiation doesn't appreciably affect the reproducibility and reliability of X-ray detection. Moreover, if the same crystal (already irradiated with alpha particles) is further exposed to a cumulative dose of 2.1kGy of X-rays, it still performs very well as a detector (dotted line). This latter aspect is quite advantageous with respect to the prior art, since it is an advantage in general for any radiation detector: this property is defined "radiation hardness" and indicates that this detector can work for a long time under heavy radiation environments. The ΔI= I_{ON}-I_{OFF} is consistently the same, even if the bulk current decreases, as we already observed for crystals irradiated only with X-rays (Figure 4). This behaviour is verified for repeated on/off cycles, and assesses how 4HCB crystals can reliably detect X-rays even after the exposure to significant cumulative doses of alpha particles and X-rays, hence in a heavily ionizing environment.

### Industrial applicability

The organic semiconductor-based intrinsic, direct detector for ionizing radiations described in the present invention can be used in all the situations where such a detector is needed.

One of the major application is in medical imaging, see A. Del Guerra, Ionizing Radiation Detectors for Medical Imaging, World Scientific Publishing Co. Pte. Ltd. 2004. Examples of use of the detector of the present invention are in X-ray imaging systems and technologies; CT scanners; mammography, also with synchrotron radiation; autoradiography systems; nuclear medicine systems; positron emission tomography systems; functional imaging systems in nuclear medicine; position sensitive detectors; single photon emission computerized tomography; gamma rays detection systems; detectors for radiotherapy.

Another application of the detector of the present invention is for civil security: ionizing radiation and active imaging devices can be employed at border crossing points, airports or naval ports (see US 2009/0302226). Another application of the detector of the present invention is in analytical techniques, see for example US 2005/205786.

Another advantageous application of the organic semiconductor-based intrinsic, direct detector for ionizing radiations described in the present invention is in roomtemperature detectors, for the same applications described above, or for different ones.

## Claims

1. Detector for ionizing radiations, comprising:
- an organic semiconductor as intrinsic, direct detector, in which the incoming ionizing radiation is transduced directly into an electrical signal such transduction occurring within said organic semiconductor interacting with the ionizing radiation, said organic semiconductor being an organic single crystal or an organic polycrystal;
- a signal processing unit; and
- electrodes connecting said processing unit to said intrinsic, direct detector,
- wherein at least one of said electrodes is organic or wherein at least one of said electrodes is an ultrathin layer having a thickness of less than 1 µm comprising a metal and/or a semimetal and/or an inorganic material.

2. Detector according to claim 1, wherein said ionizing radiations are selected from the group consisting of X-rays, gamma rays, neutrons, charged particles, in particular alpha rays, electrons, positrons.

3. Detector according to any of the preceding claims, wherein said at least one organic electrode comprises a material selected from the group consisting of conducting polymer blends, conducting polymers, doped semiconducting polymers and/or molecules, carbon nanotubes, fullerene and/or its derivatives, graphite, graphene and/or its derivatives, organic conducting charge-transfer salts.

4. Detector according to claim 3, wherein said at least one organic electrode comprises a material selected from the group consisting of PEDOT:PSS, polyaniline, doped poly(paraphenylene-vynilene) derivatives, doped poly(3-hexylthiophene) derivatives, fullerene, fullerene derivatives, carbon nanotubes, graphene and graphene oxide.

5. Detector according to any one of the preceding claims, wherein said intrinsic, direct detector is flexible.

6. Detector according to any one of the preceding claims, wherein said intrinsic, direct detector is optically transparent.

7. Detector according to any one of the preceding claims, wherein said organic semiconductor is selected from the group consisting of ortho-disubstituted benzenes, meta-disubstituted benzenes, para-disubstituted benzenes, condensed aromatic hydrocarbons, azobenzenes, conjugated acyclic molecules, organometallic molecules, boron-containing molecules, phosphor-containing molecules, silicon-containing molecules and germanium-containing molecules.

8. Detector according to claim 7, wherein said organic semiconductor is selected from the group consisting of 4-hydroxycyanobenzene, 1,8-naphthalenediimide, 2,4-dinitronaphthalen-1-ol, 9,10-anthracenedicarboxylic acid, 3,4-dihydroxy-9,10-dioxo-2-anthracenesulphonic acid sodium salt, azobenzene, 2-(4-dimethylaminophenylazo)benzoic acid, β-carotene, benzo[b]thien-2-ylboronic acid and dipotassium tris(1,2-benzenediolato-O,O')germanate.

9. Detector according to any of the preceding claims, wherein said organic single crystal said or said organic polycrystal consists of 4-hydroxycyanobenzene or of 1,8-naphthalenediimide.

10. Detector according to any of the preceding claims, wherein multiple electrodes are positioned on the crystal, with a geometrical layout allowing the detection of a two-dimensional or three-dimensional anisotropic response to an ionizing radiation to which the crystal is exposed.

11. A method for the manufacture of the detector of any one of the preceding claims, comprising
a. deposing a solution of an organic semiconductor on a substrate;
b. evaporating said solution;
c. providing the resulting organic semiconductor with electrodes and/or electrical circuits.

12. The method according to claim 11, wherein said substrate is patterned, or the electrodes defined onto the substrate are patterned.

13. The method according to claim 11 or 12, wherein, in step a) said solution is deposed with a method selected from the group consisting of inkjet printing, drop casting, spray coating, pad printing, electrospray, doctor blading and dip coating.

14. A method for the manufacture of the detector of any one of claims 1 to 10, comprising
a. growing an organic semiconductor from a solution thereof;
b. evaporating said solution;
c. deposing the resulting organic semiconductor on a substrate;
d. providing said organic semiconductor with patterned electrodes and/or electrical conductors.

15. The method according to claim 14, wherein a solvent used for said solution is selected from the group consisting of acyclic ethers, cyclic ethers, acyclic aliphatic hydrocarbons, cyclic aliphatic hydrocarbons, aromatic hydrocarbons, acyclic alcohols, cyclic alcohols, acyclic ketones, cyclic ketones, carboxylic acids, anhydrides, nitriles, halogenated solvents, water.

16. The use of an organic semiconductor, said organic semiconductor being an organic single crystal or an organic polycrystal for the manufacturing of an intrinsic, direct detector of any one of claims 1 to 10 for ionizing radiations in which the incoming ionizing radiation is transduced directly into an electrical signal such transduction occurring within said organic semiconductor interacting with the ionizing radiation.

17. An instrument or a device provided with a detector of any one of claims 1-10.

18. The instrument or device according to claim 17 for use in medical field, in particular dentistry, and medical imaging; in civil field, in particular for security check in airports, borders; in analytical techniques; in sterilizing apparatuses; in industrial quality control.

## Patentansprüche

1. Detektor für ionisierende Strahlungen, umfassend:
- einen organischen Halbleiter als intrinsischen direkten Detektor, in dem die eintretende ionisierende Strahlung direkt in ein elektrisches Signal umgewandelt wird, wobei diese Umwandlung innerhalb des mit der ionisierenden Strahlung interagierenden organischen Halbleiters erfolgt, wobei dieser organische Halbleiter ein organischer Einkristall oder ein organischer Polykristall ist;
- eine Signalverarbeitungseinheit; und
- Elektroden, die die Verarbeitungseinheit mit dem intrinsischen direkten Detektor verbinden,
- wobei mindestens eine dieser Elektroden organisch ist oder wobei mindestens eine dieser Elektroden eine Ultradünnschicht mit einer Dicke von weniger als 1 µm ist, die ein Metall und/oder ein Halbmetall und/oder ein anorganisches Material umfasst.

2. Detektor nach Anspruch 1, wobei die ionisierenden Strahlungen aus der Gruppe ausgewählt sind, die aus Röntgenstrahlen, Gammastrahlen, Neutronen, geladenen Teilchen, insbesondere Alphastrahlen, Elektronen und Positronen besteht.

3. Detektor nach einem der vorhergehenden Ansprüche, wobei die mindestens eine organische Elektrode ein Material umfasst, das aus der Gruppe ausgewählt ist, die aus leitfähigen Polymerblends, leitfähigen Polymeren, dotierten halbleitenden Polymeren und/oder Molekülen, Kohlenstoffnanoröhren, Fulleren und/oder seinen Derivaten, Graphit, Graphen und/oder seinen Derivaten und organischen leitfähigen Charge-Transfer-Salzen besteht.

4. Detektor nach Anspruch 3, wobei die mindestens eine organische Elektrode ein Material umfasst, das aus der Gruppe ausgewählt ist, die aus PEDOT:PSS, Polyanilin, dotierten Poly(para-phenylen-vinylen)-Derivaten, dotierten Poly(3-hexylthiophen)-Derivaten, Fulleren, Fulleren-Derivaten, Kohlenstoffnanoröhren, Graphen und Graphenoxid besteht.

5. Detektor nach einem der vorhergehenden Ansprüche, wobei der intrinsische direkte Detektor flexibel ist.

6. Detektor nach einem der vorhergehenden Ansprüche, wobei der intrinsische direkte Detektor optisch transparent ist.

7. Detektor nach einem der vorhergehenden Ansprüche, wobei der organische Halbleiter aus der Gruppe ausgewählt ist, die aus ortho-disubstituierten Benzolen, meta-disubstituierten Benzolen, para-disubstituierten Benzolen, kondensierten aromatischen Kohlenwasserstoffen, Azobenzolen, konjugierten acyclischen Molekülen, metallorganischen Molekülen, Bor-haltigen Molekülen, Phosphor-haltigen Molekülen, Silicium-haltigen Molekülen und Germanium-haltigen Molekülen besteht.

8. Detektor nach Anspruch 7, wobei der organische Halbleiter aus der Gruppe ausgewählt ist, die aus 4-Hydroxy-Cyanbenzol, 1,8-Naphthalindiimid, 2,4-Dinitronaphthalin-1-ol, 9,10-Anthracendicarbonsäure, 3,4-Dihydroxy-9,10-dioxo)-2-anthracensulfonsäure-Natriumsalz, Azobenzol, 2-(4-Dimethylaminophenylazo)-benzoesäure, β-Carotin, Benzothiophen-2-boronsäure und Dikalium(tris-(1,2-benzoldiolato-O,O'-germanat) besteht.

9. Detektor nach einem der vorhergehenden Ansprüche, wobei der organische Einkristall oder der organische Polykristall aus 4-Hydroxy-Cyanbenzol oder aus 1,8-Naphthalindiimid besteht.

10. Detektor nach einem der vorhergehenden Ansprüche, wobei die mehreren Elektroden auf dem Kristall mit einem geometrischen Layout angeordnet sind, das die Detektion einer zweidimensionalen oder dreidimensionalen anisotropen Reaktion auf eine ionisierende Strahlung ermöglicht, der der Kristall ausgesetzt ist.

11. Verfahren zum Herstellen des Detektors nach einem der vorherigen Ansprüche, umfassend:
a. Aufbringen einer Lösung eines organischen Halbleiters auf ein Substrat;
b. Verdampfen dieser Lösung;
c. Versehen des resultierenden organischen Halbleiters mit Elektroden und/oder elektrischen Schaltkreisen.

12. Verfahren nach Anspruch 11, wobei das Substrat strukturiert wird oder die auf dem Substrat definierten Elektroden strukturiert werden.

13. Verfahren nach Anspruch 11 oder 12, wobei in Schritt a) die Lösung mit einem Verfahren aufgebracht wird, das aus der Gruppe ausgewählt ist, die aus Tintenstrahldruck, Auftropfen, Sprühbeschichtung, Tampondruck, Elektrospray, Aufstreichen und Tauchbeschichtung besteht.

14. Verfahren zum Herstellen des Detektors nach einem der vorherigen Ansprüche von 1 bis 10, umfassend:
a. Aufwachsen eines organischen Halbleiter aus einer Lösung desselben;
b. Verdampfen dieser Lösung;
c. Aufbringen des resultierenden organischen Halbleiters auf ein Substrat;
d. Versehen dieses organischen Halbleiters mit strukturierten Elektroden und/oder elektrischen Leitern.

15. Verfahren nach Anspruch 14, wobei ein für die Lösung verwendetes Lösungsmittel aus der Gruppe ausgewählt ist, die aus acyclischen Ethern, cyclischen Ethern, acyclischen aliphatischen Kohlenwasserstoffen, cyclischen aliphatischen Kohlenwasserstoffen, aromatischen Kohlenwasserstoffen, acyclischen Alkoholen, cyclischen Alkoholen, acyclischen Ketonen, cyclischen Ketonen, Carbonsäuren, Anhydriden, Nitrilen, halogenierten Lösungsmitteln und Wasser besteht.

16. Verwendung eines organischen Halbleiters, wobei dieser organische Halbleiter ein organischer Einkristall oder ein organischer Polykristall ist, zum Herstellen eines intrinsischen direkten Detektors nach einem der Ansprüche von 1 bis 10 für ionisierende Strahlungen, in dem die eintretende ionisierende Strahlung direkt in ein elektrisches Signal umgewandelt wird, wobei diese Umwandlung innerhalb des mit der ionisierenden Strahlung interagierenden organischen Halbleiters erfolgt.

17. Instrument oder Gerät, das mit einem Detektor nach einem der Ansprüche von 1 bis 10 versehen ist.

18. Instrument oder Vorrichtung nach Anspruch 17 zur Verwendung im medizinischen Bereich, insbesondere Zahnmedizin, und zur medizinischen Bildgebung; im zivilen Bereich, insbesondere für die Sicherheitskontrolle in Flughäfen, an Grenzen; bei Analysemethoden; in Sterilisationsvorrichtungen; bei der industriellen Qualitätskontrolle.

## Revendications

1. Détecteur de rayonnements ionisants comprenant :
- un semi-conducteur organique comme détecteur direct intrinsèque, dans lequel le rayonnement ionisant d'entrée est transformé par transduction directement en un signal électrique, ladite transduction se produisant à l'intérieur dudit semi-conducteur organique interagissant avec le rayonnement ionisant, ledit semi-conducteur organique étant un monocristal organique ou un polycristal organique ;
- une unité de traitement de signal ; et
- des électrodes connectant ladite unité de traitement audit détecteur direct intrinsèque,
- dans lequel au moins une desdites électrodes est organique ou dans lequel au moins une desdites électrodes est une couche ultramince ayant une épaisseur de moins de 1 µm comprenant un métal et/ou un semi-métal et/ou un matériau inorganique.

2. Détecteur selon la revendication 1, dans lequel lesdits rayonnements ionisants sont sélectionnés à partir du groupe comprenant des rayons X, des rayons gamma, des neutrons, des particules chargée, en particulier des rayons alpha, des électrons, des positrons.

3. Détecteur selon l'une quelconque des revendications précédentes, dans lequel ladite au moins une électrode organique comprend un matériau sélectionné à partir du groupe comprenant des mélanges de polymères conducteurs, des polymères conducteurs, des molécules et/ou polymères semi-conducteurs dopés, des nanotubes de carbone, du fullerène et/ou ses dérivés, du graphite, du graphène et/ou ses dérivés, des sels à transfert de charge conducteurs organiques.

4. Détecteur selon la revendication 3, dans lequel ladite au moins une électrode organique comprend un matériau sélectionné à partir du groupe comprenant le DEPOT:PSS, la polyaniline, des dérivés de poly(paraphénylène-vynilène) dopés, des dérivés de poly(3-hexylthiophène) dopés, du fullerène, des dérivés de fullerène, des nanotubes de carbone, du graphène et de l'oxyde de graphène.

5. Détecteur selon l'une quelconque des revendications précédentes, dans lequel ledit détecteur direct intrinsèque est flexible.

6. Détecteur selon l'une quelconque des revendications précédentes, dans lequel ledit détecteur direct intrinsèque est optiquement transparent.

7. Détecteur selon l'une quelconque des revendications précédentes, dans lequel ledit semi-conducteur organique est sélectionné à partir du groupe comprenant des benzènes ortho-disubstitués, des benzènes méta-disubstitués, des benzènes para-disubstitués, des hydrocarbures aromatiques condensés, des azobenzènes, des molécules acycliques conjuguées, des molécules organométalliques, des molécules contenant du bore, des molécules contenant du phosphore, des molécules contenant du silicium, et des molécules contenant du germanium.

8. Détecteur selon la revendication 7, dans lequel ledit semi-conducteur organique est sélectionné à partir du groupe comprenant le 4-hydroxylcyanobenzène, 1,8-naphthalènediimide, le 2,4-dinitronaphthalène-1-ol, l'acide 9,10-anthracènedicarboxylique, le sel de sodium d'acide 3,4-dihydroxy-9,10-dioxo-2-anthracènesulphonique, l'azobenzène, l'acide 2-(4-diméthylaminophénylazo)benzoïque, la β-carotène, l'acide benzo[b]thien-2-ylboronique et le tris(1,2-benzènediolato-O,O')germanate de dipotassium.

9. Détecteur selon l'une quelconque des revendications précédentes, dans lequel ledit monocristal organique ou ledit polycristal organique comprend le 4-hydroxylcyanobenzène ou le 1,8-naphthalènediimide.

10. Détecteur selon l'une quelconque des revendications précédentes, dans lequel de multiples électrodes sont positionnées sur le cristal, avec une configuration géométrique permettant la détection d'une réponse anisotrope en deux dimensions ou en trois dimensions d'un rayonnement ionisant auquel le cristal est exposé.

11. Procédé pour la fabrication du détecteur selon l'une quelconque des revendications précédentes, comprenant :
a. le dépôt d'une solution d'un semi-conducteur organique sur un substrat ;
b. l'évaporation de ladite solution ;
c. le fait de pourvoir le semi-conducteur organique résultant d'électrodes et/ou de circuits électriques.

12. Procédé selon la revendication 11, dans lequel ledit substrat est structuré, ou les électrodes définies sur le substrat sont structurées.

13. Procédé selon la revendication 11 ou 12, dans lequel, dans l'étape a), ladite solution est déposée avec un procédé sélectionné à partir du groupe comprenant l'impression à jet d'encre, le matriçage, le revêtement par pulvérisation, l'impression au tampon, l'électro-pulvérisation, le raclage et le revêtement par immersion.

14. Procédé pour la fabrication du détecteur selon l'une quelconque des revendications 1 à 10, comprenant :
a. la croissance d'un semi-conducteur organique à partir d'une solution de celui-ci ;
b. l'évaporation de ladite solution ;
c. le dépôt du semi-conducteur organique résultant sur un substrat ;
d. le fait de munir ledit semi-conducteur organique d'électrodes et/ou de conducteurs électriques structurés.

15. Procédé selon la revendication 14, dans lequel un solvant utilisé pour ladite solution est sélectionné à partir du groupe comprenant des éthers acycliques, des éthers cycliques, des hydrocarbures aliphatiques acycliques, des hydrocarbures aliphatiques cycliques, des hydrocarbures aromatiques, des alcools acycliques, des alcools cycliques, des cétones acycliques, des cétones cycliques, des acides carboxyliques, des anhydrides, des nitriles, des solvants halogénés, l'eau.

16. Utilisation d'un semi-conducteur organique, ledit semi-conducteur organique étant un monocristal organique ou un polycristal organique pour la fabrication d'un détecteur direct intrinsèque selon l'une quelconque des revendications 1 à 10 pour des rayonnements ionisants, dans lequel le rayonnement ionisant d'entrée est transformé par transduction directement en un signal électrique, ladite transduction se produisant à l'intérieur dudit semi-conducteur organique interagissant avec le rayonnement ionisant.

17. Instrument ou dispositif muni d'un détecteur selon l'une quelconque des revendications 1 à 10.

18. Instrument ou dispositif selon la revendication 17 pour l'utilisation dans le domaine médical, en particulier la dentisterie, et l'imagerie médicale ; dans le domaine civil, en particulier pour le contrôle de sécurité dans les aéroports, aux frontières ; dans des techniques analytiques ; dans des appareils de stérilisation ; dans le contrôle de qualité industriel.
